**Europäisches Patentamt**

**European Patent Office**

**Office européen des brevets**

(19)

(11) **EP 0 991 797 B1**

(12) **EUROPÄISCHE PATENTSCHRIFT**

(45) Veröffentlichungstag und Bekanntmachung des Hinweises auf die Patenterteilung:
**24.07.2002 Patentblatt 2002/30**

(51) Int Cl.⁷: **C30B 13/02**, H01L 21/24, H01L 31/0224, H01L 21/768, H01L 23/48

(21) Anmeldenummer: **98943631.6**

(22) Anmeldetag: **22.06.1998**

(86) Internationale Anmeldenummer:
**PCT/DE98/01768**

(87) Internationale Veröffentlichungsnummer:
**WO 98/59098 (30.12.1998 Gazette 1998/52)**

(54) **VERFAHREN UND VORRICHTUNG ZUR HERSTELLUNG ELEKTRISCH LEITFÄHIGER DURCHGÄNGE IN HALBLEITER-BAUELEMENTEN**

METHOD AND DEVICE FOR PRODUCING ELECTRICALLY CONDUCTIVE CONTINUITY IN SEMICONDUCTOR COMPONENTS

PROCEDE ET DISPOSITIF POUR L'OBTENTION DE PASSAGES ELECTRO-CONDUCTEURS DANS DES COMPOSANTS SEMI-CONDUCTEURS

(84) Benannte Vertragsstaaten:
**AT CH DE ES FR GB IT LI NL SE**

(30) Priorität: **20.06.1997 DE 19727693**

(43) Veröffentlichungstag der Anmeldung:
**12.04.2000 Patentblatt 2000/15**

(73) Patentinhaber:
• **Dr. Johannes Heidenhain GmbH**
  **83301 Traunreut (DE)**
• **Silicon Sensor GmbH**
  **12459 Berlin (DE)**

(72) Erfinder:
• **KRIEGEL, Bernd**
  **D-12459 Berlin (DE)**

• **KUDELLA, Frank**
  **D-12589 Berlin (DE)**
• **ARNOLD, Rene**
  **D-10178 Berlin (DE)**

(74) Vertreter: **Ninnemann, Detlef, Dipl.-Ing. et al Patentanwälte Maikowski & Ninnemann, Postfach 15 09 20**
**10671 Berlin (DE)**

(56) Entgegenhaltungen:
| | |
|---|---|
| EP-A- 0 101 762 | WO-A-83/03710 |
| US-A- 4 097 226 | US-A- 4 101 759 |
| US-A- 4 141 757 | US-A- 4 157 564 |
| US-A- 4 159 215 | US-A- 4 221 956 |
| US-A- 4 224 504 | |

## Beschreibung

Die Erfindung bezieht sich auf ein Verfahren zur Herstellung elektrisch leitfähiger Durchgänge in Halbleiter-Bauelementen sowie auf eine Vorrichtung zur Durchführung des Verfahrens.

Aus der US-A-4 159 215 ist ein Verfahren zum Durchdringen eines aus dotiertem Silizium, Germanium oder dergleichen bestehenden halbleitenden Grundkörpers eines Halbleiter-Bauelementes, das einander gegenüberstehende Oberflächen aufweist, mit einer Legierung mit Aluminium als Trägermaterial und Phosphor, Arsen oder Antimon als Dotierung mittels Temperaturgradienten-Zonenschmelzens bekannt. Das Halbleiter-Bauelement wird in einer Metalldampfkammer angeordnet und eine Aluminium-Antimonschicht mit einer Schichtdicke von 0,5 µm - 25 µm auf eine der beiden Oberflächen des Halbleiter-Bauelements aufgebracht. Mittels Photolithographie werden die Migrationsbereiche festgelegt und das so vorbereitete Bauelement in einer Thermomigrationsvorrichtung angeordnet. Durch einen an den halbleitenden Grundkörper über eine ausreichende Zeitdauer angelegten Temperaturgradienten von etwa 50 °C zwischen der wärmeren Bodenfläche und der kühleren Oberfläche durchdringt die Legierung den Halbleiterkörper. Anschließend werden die auf der Bodenfläche des Halbleiter-Bauelementes vorhandenen Legierungsbereiche weggeätzt oder abgeschliffen und es verbleiben die mittels Thermomigration hergestellten Kanäle aus rekristallisiertem Halbleitermaterial und gelöstem Metall.

Derartige von einer Oberfläche zur gegenüberliegenden Oberfläche eines Halbleiter-Bauelementes verlaufende Kanäle werden insbesondere bei SMD (Surface Mounted Devices)-Bauelementen verwendet, die so ausgebildet sind, daß die Kontaktstellen beider Elektroden auf einer Oberfläche (der Rückseite) des Bauelements angeordnet werden können. Ein derartiges Bauelement kann mit seiner Rückseite an eine mit geeigneten Kontaktflächen versehene Leiterplatte angeschlossen werden, ohne daß zusätzliche Drähte oder andere Verbindungselemente benötigt werden.

Ein besonderes Anwendungsgebiet sind optoelektronische Sensor-Bauelemente, d.h. Strahlungsempfänger, die elektromagnetische Strahlungsenergie (Photonen) in elektrische Signale umwandeln und in der Meßtechnik von großer Bedeutung sind. Beispielsweise werden in Positionsmeßsystmen, wie Längenund Winkelmeßsystemen (inkrementaler oder absoluter Art) hinter einer Gitterstruktur mehrere Strahlungsempfänger (insbesondere Fotoelemente) angeordnet.

Derartige Strahlungsempfänger sind in der Regel als Sperrschicht-Fotodetektoren ausgebildet. Sie enthalten einen PN-, PIN-, MS- oder MOS-Übergang, in dem die Umwandlung elektromagnetischer Strahlungsenergie in ein elektrisches Signal mittels des Fotosperrschichteffektes erfolgt. Um das elektrische Signal messen und auswerten zu können, muß der Strahlungsempfänger mit elektrischen Kontakten versehen sein und an eine geeignete elektrische Schaltung angeschlossen werden. Diese Integration in eine elektrische Schaltung erfolgt häufig auf einer Leiterplatte, wobei die Strahlungsempfänger vorzugsweise als SMD-Bauelemente ausgebildet sind.

Zur Herstellung einer elektrisch leitfähigen Verbindung von einer Oberfläche zur gegenüberliegenden Oberfläche eines halbleitenden Grundkörpers wird beispielsweise ein zylindrischer, halbleitender Kanal vom p-Typ zwischen der p-leitenden Schicht und der rückseitigen Oberfläche des Halbleiter-Bauelements hergestellt, der vorzugsweise einen Durchmesser von 30 µm bis 100 µm aufweist und neben anderen Verbindungsverfahren mittels Thermomigration hergestellt werden kann.

Das Prinzip der Thermomigration beruht darauf, daß die Löslichkeit metallischer Dotierungsstoffe in halbleitenden Materialien, wie z.B. Silizium, temperaturabhängig ist und mit steigender Temperatur zunimmt. Wird zwischen zwei gegenüberliegenden Oberflächen eines hinreichend erwärmten Halbleiterbauelementes ein Temperaturgradient erzeugt und auf die kühlere Oberfläche des Bauelementes ein geeigneter metallischer Dotierungsstoff aufgebracht (z. B. Aluminium zur p-Dotierung von n-leitenden Bereichen), so migriert der metallische Dotierungsstoff zu der gegenüberliegenden, wärmeren Oberfläche des Halbleiterbauelementes. Durch entsprechende Strukturierung der kühleren Oberfläche, auf die der Dotierungsstoff aufgebracht wird, z.B. mit Hilfe von Oxid-Schichten, läßt sich die Gestalt derartiger Kanäle gezielt einstellen.

Aus der US 4 221 956 und der US 4 224 504 ist es bekannt, den Migrationsprozess in einer geschlossenen Kammer durchzuführen und den Halbleiter auf Stege mit festem Abstand gegenüber der Kühleinrichtung aufzulegen.

In der WO 83 03710 wird ein Verfahren zur Durchführeung des Thermomigrationsprozesses an Halbleitern beschrieben, bei dem der entsprechend vorbereitete Halbleiter mit der einen Oberfläche auf eine im wesentlichen ebene Oberfläche einer Wärmequelle gelegt wird, so daß er an Oberfläche der Wärmequelle anliegt. Der Halbleier wird aufgeheizt, wobei eine Temperaturdifferenz zwischen den beiden Oberflächen des Halbleiters aufgebaut wird. Auf den Halbleiter aufgebrachte Tropfen von entgegensetzt leitendem Material wandern dabei, wie durch den Halbleiter und bilden leitende Verbindungen zwischen den beiden Oberflächen. Anschließend wird das Heizelement abgekühlt und der Halbleiter entnommen. Durch den direkten Kontakt zwischen Halbleiter und Wärmequelle wird ein hoher Temperaturgradient in dem Halbleiter erzeugt und somit eine Beschleunigung des Verfahrens erreicht. Nachteil des Standes der Technik ist, daß eine gleichmäßige Temperaturführung auf diese Art kaum möglich ist.

Ausgehend von diesem Stand der Technik lag der Erfindung die Aufgabenstellung zu Grunde, bei der Herstellung von Halbleiter-Bauelementen mittels Thermomigration die Einstellung Oberflächentemperatur des Halbleiters während der Durchführung des Verfahrens so zu führen, daß ein sicheres Durchdringen leitfähiger Durchgangskanäle durch den Halbleiter-Wafer mit festgelegten pn-Übergängen in minimaler Zeit - möglicht ist, ohne daß die Dotierüngen der Halbleiter-Bauelemente infolge der Aufheizung des Halbleiter-Wafers beeinflußt werden oder die Form des Halbleiter-Wafers verändert wird. Darüber hinaus sollen Wechselwirkungen zwischen der Oberfläche der Wärmequelle bzw. der Kühleinrichtung und dem Wafer vermieden werden.

Diese Aufgabe wird erfindungsgemäß durch ein Verfahren mit den Merkmalen des Anspruchs 1 gelöst.

Die Oberflächentemperatur des Halbleiters wird an mindestens einem Temperaturmeßpunkt gemessen und diese Temperatur bildet die Basis für die Steuerung der Gesamtleistung des Wärmeeintrags in den Halbleiter (10) und/ oder die Leistungsverteilung des Wärmeeintrags über die zu erwärmende Oberfläche des Halbleiters (10). Diese Steuerung erfolgt durch Veränderung der Abstände (a1, a2) zwischen Halbleiter und Heiz- bzw. Kühlelement.

Das erfindungsgemäße Verfahren gewährleistet durch gezielte Temperaturregelung über die Zeitdauer des Thermomigrationsprozesses sowie über die gesamte Fläche eines Halbleiter-Wafers bei gleichzeitigem Ausschluß von Verunreinigungen während des Prozesses ein sicheres Durchdringen der halbleitenden Grundkörper der auf dem Halbleiter-Wafer angeordneten Halbleiter-Bauelemente in minimaler Zeit und stellt sicher, daß die Dotierungen der Halbleiter-Bauelemente infolge der Aufheizung des Halbleiter-Wafers und die Form des Halbleiter-Wafers beispielsweise durch Verbiegen infolge der auf den Halbleiter-Wafer einwirkenden Wärmestrahlung nicht beeinflußt werden.

Eine vorteilhafte Ausgestaltung der erfindungsgemäßen Lösung ist dadurch gekennzeichnet, daß der Halbleiter in einem geschlossenen, mit einem vorzugsweise gut wärmeleitenden Inertgas gefüllten System angeordnet wird.

Durch das Einbringen des Halbleiters in ein geschlossenes, mit einem Inertgas gefülltes System werden Verunreinigungen am Halbleiter vermieden und sowohl der Wärmestrom zum Erhitzen der einen Oberfläche des Halbleiters als auch die Kühlung der anderen Oberfläche des Halbleiters optimiert.

Dabei ist es besonders bevorzugt, Helium im laminaren Strömungsbereich bei einem Druck von 0,1 mbar bis 30 mbar einzusetzen.

Die Wirksamkeit und Steuerbarkeit der Wärmeverteilung auf dem Halbleiter wird nach einem weiteren Merkmal der Erfindung dadurch verbessert, daß die Oberflächen des Halbleiters in voneinander getrennten Räumen angeordnet werden, so daß durch die Einkopplung der Energie zur Erwärmung des Halbleiters über das gut wärmeleitende Gas und weniger über beispielsweise Strahlungsenergie erfolgt.

Eine vorteilhafte Ausgestaltung der erfindungsgemäßen Lösung ist dadurch gekennzeichnet, daß der Halbleiter senkrecht zur Ebene zwischen der Wärmequelle und der Kühleinrichtung zu bewegen ist. Damit kann das Einbringen des Halbleiters in die Thermomigrationsvorrichtung und seine Entnahme durch das Verfahren des Halbleiters von einer Beschickungs- in eine Erwärmungsposition und umgekehrt erleichtert werden.

Vorzugsweise wird die Temperatur des Halbleiters mit einer pyrometrischen Meßeinrichtung über einen optischen Meßkanal berührungsfrei gemessen.

Nach einem weiteren Merkmal der erfindungsgemäßen Lösung wird der Halbleiter mit einem Temperaturanstieg kleiner oder gleich 30 K/Sekunde aufgeheizt, anschließend wird die Temperatur konstant gehalten, bis der Thermomigrationsprozess abgeschlossen ist, in einer ersten Abkühlphase wird mit abnehmender Wärmestrahlung abgekühlt und anschließend über eine vorgegebene Zeitspanne in freier Abkühlung bis zur Entnahmetemperatur abgekühlt.

Weiter vorteilhafte Weiterbildungen und Ausgestaltungen des erfindungsgemäßen Verfahrens sind den Merkmalen der Ansprüche 10 bis 12 zu entnehmen.

Eine Vorrichtung zur Herstellung elektrisch leitfähiger Durchgänge in einem scheibenförmigen Halbleiter mittels Thermomigration durch Erzeugen eines Temperaturgradienten zwischen zwei entgegengesetzten Oberflächen des Halbleiters, von denen eine Oberfläche einer Wärmequelle (6) und die andere Oberfläche einer Kühleinrichtung (11) zugewandt ist, und Aufbringen eines leitfähigen Dotierungsstoffes auf die der Wärmequelle (6) zugewandten Oberfläche mit einer zwischen der Wärmequelle (6) und der Kühleinrichtung (11) angeordnete Auflage zur Aufnahme des Halbleiters, wobei die Wärmequelle (6) eine homogene Wärmestrahlung an die ihr zugewandte Oberfläche des Halbleiters (10) abgibt, ist durch einen Pyrometermeßkopf zur Messung der Oberflächentemperatur des Halbleiters und durch Veränderung des Abstandes zwischen der Auflage und der Wärmequelle und/oder zwischen der Auflage und der Kühleinrichtung in Abhängigkeit von der gemessenen Oberflächentemperatur gekennzeichnet.

Dadurch daß die Abstände zwischen der Auflage zur Wärmequelle bzw. zur Kühleinrichtung in Abhängigkeit von der gemessenen Temperatur gesteuert werden, ist eine eine exakte Temperatursteuerung zur Optimierung des Ablaufs des Thermomigrationsprozesses innerhalb kürzestmöglicher Zeit möglich, gewährleistet einen hohen Reinheitsgrad, eine geringstmögliche Beeinflussung der Halbleiter-Dotierungen und stellt sicher, daß der Halbleiter-Wafer nicht durch Temperaturveränderungen in seiner ebenen Form verändert wird.

Eine vorteilhafte Ausgestaltung der erfindungsgemäßen Vorrichtung ist dadurch gekennzeichnet, daß der Raum zwischen der Wärmequelle und der Kühleinrichtung gekapselt und vorzugsweise mit einem inerten, gut wärmeleitenden Gas, insbesondere mit Wasserstoff oder Helium gefüllt ist.

Durch die Verwendung eines inerten, gut wärmeleitenden Gases werden Reaktionen von Gaspartikeln mit dem Halbleiter und der Heizeinrichtung vermieden und gleichzeitig wird ein großer Wärmestrom zum Erwärmen der einen Oberfläche des Halbleiters sowie eine entsprechend gute Kühlung der entgegengesetzten Oberfläche des Halbleiters zur Optimierung des Thermomigrationsprozesses gewährleistet.

Durch eine Unterteilung des Raumes in der Ebene der Auflage wird eine Systemtrennung bewirkt, die Voraussetzung für eine optimierte Steuerung der Erwärmung und Abkühlung des Halbleiters während des Thermomigrationsprozesses und zur Vermeidung von Verwerfungen an einem Halbleiter-Wafer ist.

Eine Form der Steuerung besteht nach einem weiteren Merkmal der Erfindung darin, daß der Gasdruck und/ oder die Gasströmung in dem Raum bzw. den Räumen veränderbar ist.

Eine Weiterbildung der erfindungsgemäßen Vorrichtung ist dadurch gekennzeichnet, daß die Wärmequelle aus einem direkt oder indirekt beheizten Ofen besteht. Durch diese Ausführungsform der Wärmequelle wird eine homogene Wärmeverteilung in der dem Ofen zugewandten Oberseite des Halbleiters bzw. Halbleiter-Wafers gewährleistet und ein Verbiegen des Halbleiters bzw. Halbleiter-Wafers infolge einer ungleichmäßigen Erwärmung vermieden.

Vorzugsweise weist der Ofen eine im wesentlichen der Fläche der Auflage entsprechende Platte auf, die mittels elektrischer Widerstandsheizung, induktiver Heizung, Elektronenstrahl-Heizung oder mittels Mikrowellenheizung aufheizbar ist. Die Platte besteht insbesondere aus einem pyrolytisch vorzugsweise mit Bohrnitrid versiegeltem Graphitmaterial oder aus Reinstkeramik. Da die Platte vorzugsweise in einem Vakuum angeordnet wird, um die von der Platte ausgesandte Wärmestrahlung zur Optimierung des Wirkungsgrades der Thermomigrationsvorrichtung ausschließlich auf den Halbleiter zu richten, besteht die Gefahr der Verdampfung von im Raum befindliche Teilchen an der Platte und damit die Gefahr der Veränderung der Halbleiterstruktur, was durch eine entsprechend chemisch und physikalisch inaktive versiegelung oder Materialauswahl der Platte vermieden wird.

Eine Ausgestaltung der erfindungsgemäßen Lösung ist dadurch gekennzeichnet, daß die Wärmequelle aus einem Halogenlampenfeld besteht, das sich zumindest über die Fläche des Halbleiter-Wafers erstreckt, wobei das Halogenlampenfeld vorzugsweise aus einem in zwei Ebenen angeordneten, gekreuzten Halogenlampenfeld besteht.

Das vorzugsweise gekreuzte Halogenlampenfeld ermöglicht eine individuelle Steuerbarkeit des Wärmeeintrags in den Halbleiter-Wafer und eine exakte, gleichmäßige Erwärmung über dessen gesamte Fläche, so daß eine homogene Wärmestrahlung auf die dem Halogenlampenfeld zugewandte Oberfläche des Halbleiter-Wafers gewährleistet wird. Durch den regelbaren Temperaturverlauf über die Halbleiter-Waferoberfläche besteht die Möglichkeit, die Temperatur zum Rand der Wafer-Oberfläche hin anzuheben, so daß ein individuelles Temperaturprofil über die Wafer-Oberfläche eingestellt werden kann. Diese Einstellbarkeit der Lichtstimmung, d.h. der Leistungsverteilung zur Temperaturhomogenisierung, gewährleistet gleiche Verhältnisse über die gesamte Oberfläche des Halbleiter-Wafers, so daß mittels eines speziellen Temperatur-Meßverfahrens optimale Bedingungen zur Thermomigration eingestellt werden können.

Eine vorteilhafte Weiterbildung der erfindungsgemäßen Lösung ist dadurch gekennzeichnet, daß der Probenstempel aus einem Probenzylinder, einem die Deckfläche des Probenzylinders bildenden, den Halbleiter-Wafer aufnehmenden Probenkopf, einem an der Unterseite des Probenzylinders nach außen abstehenden Probenflansch und einem den Probenzylinder zur Unterseite gasdicht abschließenden Hubteller besteht, wobei vorzugsweise der Probenstempel in axialer Richtung in einen Rezipienten, der aus einer dem Halogenlampenfeld zugewandten Strahlendurchtrittsfläche und einem Quarzzylinder besteht, ein- und ausfahrbar ist.

Die Zylinderform der Probenaufnahme gewährleistet eine Trennung des Prozeßraumes von der Umgebung, so daß der Thermomigrationsprozeß unter Reinstbedingungen durch Einbringen eines Inertgases in den Prozeßraum ablaufen und dabei sichergestellt ist, daß die Zufuhr von Kühlflüssigkeit und Prozeßgasen aus Dichtungsgründen hinreichend weit entfernt von der Erwärmungsstellung des Halbleiter-Wafers erfolgt und über diese Entfernung eine ausreichende Abkühlung gewährleistet ist.

Eine Weiterbildung der erfindungsgemäßen Lösung ist dadurch gekennzeichnet, daß zentrisch innerhalb des Probenzylinders des Probenstempels ein Pyrometer-Meßkopf angeordnet ist, der über einen Temperaturmeß- und Gaskanal sowie ein im Temperaturmeß- und Gaskanal befindliches Meßfenster auf die dem Probenkopf zugewandte Oberfläche des Halbleiter-Wafers gerichtet ist, wobei der Pyrometer-Meßkopf mittels eines Pyrometerflansches am Probenstempel fixiert und justiert ist, mit einer Wellenlänge von vorzugsweise 2,2 μm arbeitet und einen fein einstellbaren Fokuskegel aufweist, der so auf die Oberfläche des Halbleiter-Wafers gerichtet ist, daß sich ein kleiner Meßfleck in der Mitte des Halbleiter-Wafers ergibt.

Die Fixierung und Justierung des Pyrometer-Meßkopfes gewährleistet einen fein einstellbaren Fokuskegel, der einen nur kleinen Fleck auf dem Halbleiter-Wafer erfaßt, so daß infolge der Temperaturmessung keine wesentliche Störung zwischen dem Halbleiter-Wafer und dem Probenkopf auftritt. Dieser Meßfleck ist repräsentativ für die Temperatur auf dem gesamten Halbleiter-Wafer, da die Leistungsverteilung über die Oberfläche des Halbleiter-Wafers mittels der individuell steuerbaren Halogenlampen des gekreuzten Halogenlampenfeldes einstellbar ist.

Der Probenkopf weist vorzugsweise drei Kopfebenen auf, von denen die Probenaufnahme mit der ersten Probenkopfebene verbunden ist, die den zentralen Temperaturmeß- und Gaskanal sowie mehrere radial verteilte, diagonal durch die erste Probenkopfebene geführte Gaskanäle aufweist, durch die ein gut wärmeleitendes Gas wie Helium oder Wasserstoff geleitet und über düsenförmige Öffnungen der Kanäle austritt und unter den Halbleiter-Wafer strömt. Die Gaszufuhr dient der Reinhaltung des Prozeßraumes, wobei der Durchfluß vorzugsweise mit 0,5 bis 50 mbar/l Gasstrom so eingestellt wird, daß der Halbleiter-Wafer durch den Gasstrom nicht angehoben wird und keine Inhomogenitäten auftreten.

Anhand eines in der Zeichnung dargestellten Ausführungsbeispiels soll der der Erfindung zugrundeliegende Gedanke näher erläutert werden. Es zeigen:

Figur 1 -      einen Querschnitt durch ein optoelektronisches Sensor-Bauelement mit einem zylindrischen, halbleitenden Verbindungskanal von der Vorder- zur Rückseite des Halbleiter-Bauelements;

Figur 2a -     eine schematische Prinzipdarstellung einer Vorrichtung zur Herstellung elektrisch leitfähiger Durchgänge in einem scheibenförmigen Halbleiter mittels Thermomigration;

Figur 2b -     eine schematische Darstellung eines Halbleiter-Wafers;

Figur 2c -     einen Querschnitt durch eine Vorrichtung gemäß Figur 2a mit Stiften oder Stegen zur Abstützung eines Halbleiter-Wafers;

Figur 2d -     eine Seitenansicht einer Vorrichtung zum Erzeugen von Durchgangskanälen in einem Halbleiter-Wafer mittels eines Lampenfeldes als Wärmequelle;

Figur 3 -      einen Längsschnitt durch einen Probenbehälter mit Außenkühlung zur Aufnahme eines Halbleiter-Wafers ;

Figur 4 -      einen schematischen Längsschnitt durch einen Teil eines Probenbehälters mit Innenkühlung;

Figur 5 -      Längsschnitte durch die einzelnen Ebenen eines Probenkopfes;

Figur 6 -      eine Draufsicht auf die erste Ebene des Probenkopfes und

Figur 7 -      ein schematisches Themperatur-Zeitdiagramm des erfindungsgemäßen Thermomigrationsprozesses.

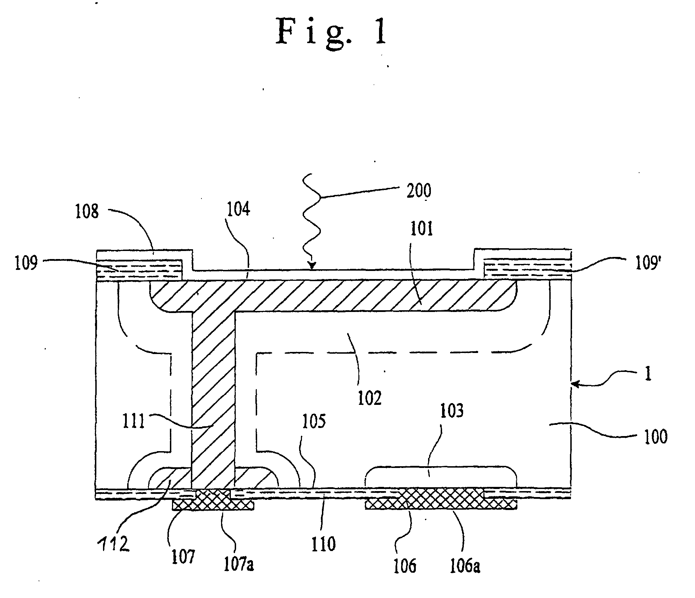

Der in Figur 1 dargestellte Schnitt durch ein optoelektronisches Sensor-Bauelement als Beispiel für die Anwendung des erfindungsgemäßen Verfahrens zur Herstellung leitfähiger Kanäle durch einen halbleitenden Grundkörper eines Halbleiter-Bauelements zeigt ein Halbleiter-Bauelement 1, dessen Grundkörper aus Silizium besteht und eine breite n-leitende Schicht 100 (300 µm bis 400 µm dick) umfaßt, an deren vorderer Oberfläche sich eine wesentlich dünnere p-leitende Schicht 101 (ca. 0.55 µm dick) erstreckt. Zwischen den beiden halbleitenden Schichten 100, 101 bildet sich eine Raumladungszone 102 (Verarmungszone) aus, die als Sperrschicht wirkt.

Die Vorderseite des Bauelements 1 ist mit einer Antireflexionsschicht 108 versehen und wird durch isolierende Schichten 109 und 109' strukturiert, die z. B. aus Siliziumdioxid bestehen können. Zwischen den beiden isolierenden Schichten 109, 109' erstreckt sich der strahlungsseitige Oberflächenbereich 104, der durch eine Oberfläche der p-leitenden Schicht 101 gebildet wird. Auf den Oberflächenbereich 104 auftreffende elektromagnetische Strahlung 200 gelangt durch die p-leitende Schicht 101 in die Raumladungszone 102 und wird dort zu einem großen Teil absorbiert. Dabei entstehen in der Raumladungszone 102 Elektron-Lochpaare. Das Raumladungsfeld trennt diese Trägerpaare; Elektronen fließen zur n-, Löcher zur p-Seite. Um diesen Fotostrom, der ein Maß für die einfallende Strahlungsleistung ist, messen zu können, muß das Bauelement 1 in eine geeignete elektrische Schaltung integriert werden. Häufig umfaßt eine solche elektrische Schaltung mehrere Fotoelemente und weitere halbleitende Bauelemente, die gemeinsam auf einer Leiterplatte angeordnet werden.

Zum Anschluß des Bauelements 1 an eine derartige elektrische Schaltung sind auf dessen durch isolierende Schichten 110 strukturierter rückseitiger Oberfläche 105 Elektroden 106 und 107 mit flächigen Kontaktstellen 106a und 107a aus lötfähigem Material vorgesehen. Die rückseitige Oberfläche 105 wird dabei durch durch eine Oberfläche der n-leitenden Schicht 100 selbst gebildet. Die Anschlußelektrode 106 der n-leitenden Schicht 100 ist an einem niederohmigen, stark dotierten Bereich 103 der halbleitenden Schicht 100 angeordnet, um den Kontaktwiderstand zu minimieren.

Um die Anschlußelektrode 107 der p-leitenden Schicht 101 ebenfalls an der rückseitigen Oberfläche 105 des Bauelements 1 anordnen zu können, erstreckt sich ein zylindrischer, halbleitender Kanal 111 vom p-Typ von der p-leitenden Schicht 101 zur rückseitigen Oberfläche 105 des Bauelements 1. Der p-leitende Kanal 111 hat vorzugsweise einen Durchmesser von 30 µm bis 100 µm und wird mittels Thermomigration hergestellt.

Das rückseitige Ende des Durchgangs 111 ist außerdem von einem zusätzlichen p-leitenden Bereich 112 umgeben, der z.B. durch Ionenimplantation oder -diffusion hergestellt werden kann und der eine einwandfreie Kontaktierung der p-leitenden Schicht 101 über den zylindrischen Bereich 111 und die Elektrode 107 ermöglicht. Die Ausdehnung des zusätzlichen p-leitenden Bereichs 112 wird derart gewählt, daß er den oberflächennahen Abschnitt des zylindrischen Bereichs 111 soweit umschließt, daß die bei der Herstellung des zylindrischen Bereichs 111 in Oberflächennähe auftretenden Störungen in der elektronischen Struktur möglichst weitgehend eliminiert werden. Die Dicke des zusätzlichen p-leitenden Bereichs liegt in der Größenordnung von 0,6 μm.

Aufgrund der auf der rückseitigen Oberfläche 105 des Bauelements 1 nebeneinander liegenden Elektroden 106 bzw. 107 der n-leitenden Schicht 100 und der p-leitenden Schicht 101 läßt sich das Bauelement 1 sehr einfach an eine Leiterplatte anschließen und dadurch in eine elektrische Schaltung integrieren. Dazu müssen lediglich die Elektroden 106 und 107 mit ihren Kontaktstellen 106a und 107a auf dafür vorgesehene Kontaktflächen der Leiterplatte aufgesetzt und durch Löten oder Ultraschallschweißen befestigt werden. Zusätzliche Verbindungselemente, wie z.B. Lötbrücken, zwischen den Elektroden des Bauelementes 1 und der Leiterplatte sind nicht notwendig.

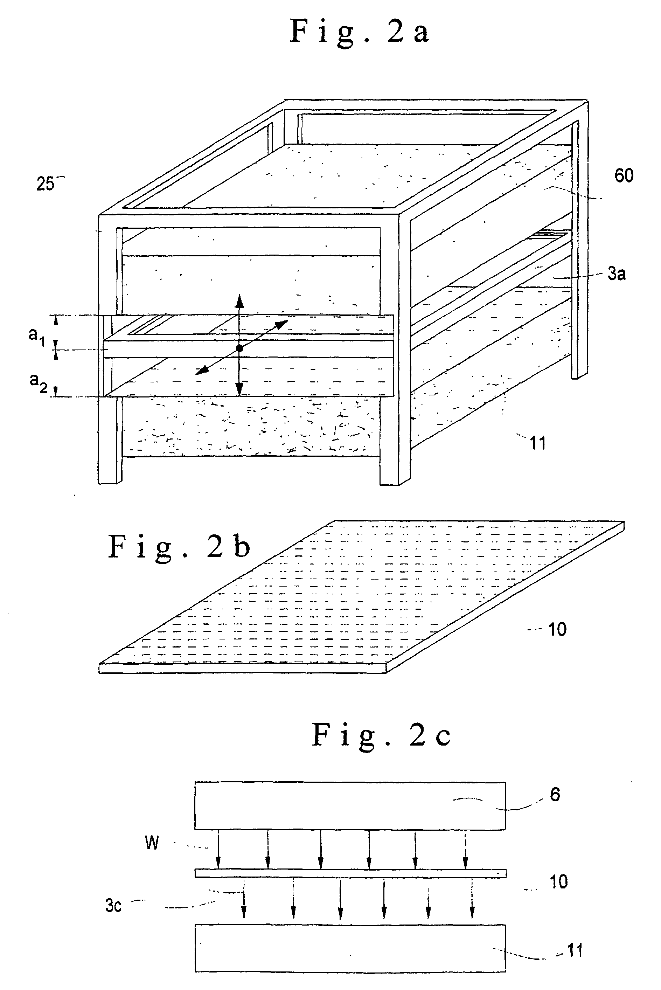

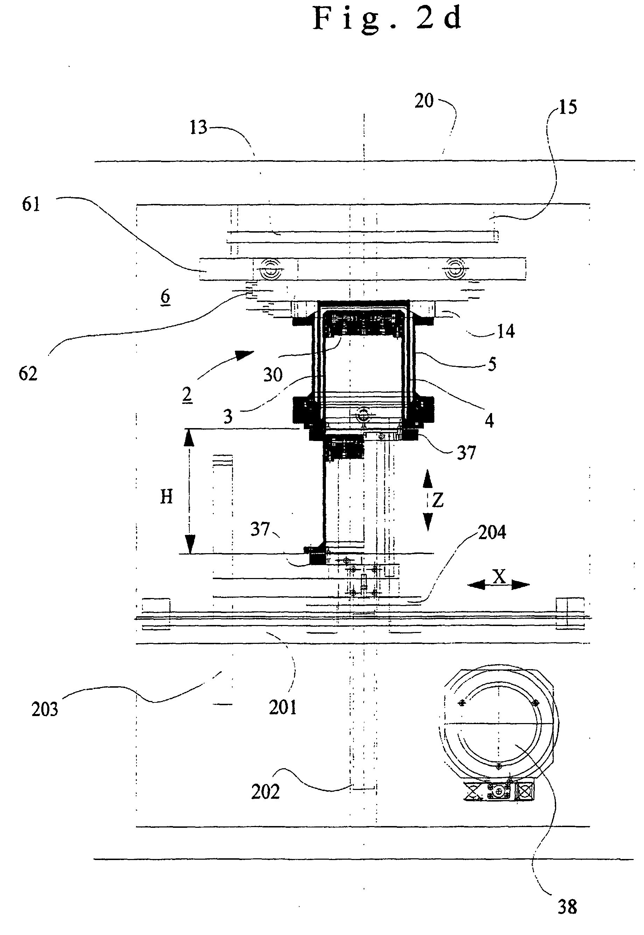

Die leitfähigen Kanäle im halbleitenden Grundkörper eines Halbleiter-Bauelements gemäß Figur 1 werden beispielsweise mit Vorrichtungen erzeugt, die schematisch in den Figuren 2a und 2c und in ihrer Gesamtheit mit einem Lampenfeld als Wärmequelle in Figur 2d dargestellt sind. Sie dienen zur Aufnahme eines Halbleiter-Wafers, d.h. einer Platine mit einer Vielzahl von Halbleiter-Bauelementen, die entsprechend ihrer Aufgabenstellung und Anwendung dotiert und konfiguriert sind. Neben den in den Figur 2a, 2c und 2d dargestellten Vorrichtungen sind auch andere, gleichwirkende Vorrichtungen zur Aufnahme von Halbleiter-Wafern und Herstellung leitfähiger Kanäle von der einen zur anderen Oberfläche der auf dem Halbleiter-Wafer angeordneten Halbleiter-Bauelemente möglich.

Die in Figur 2a als Funktionsschema dargestellte Vorrichtung zur Herstellung elektrisch leitfähiger Durchgänge in scheibenförmigen Halbleitern mittels Thermomigration besteht aus einem Gestell 25, in dem eine Platte 60 einer Wärmequelle, insbesondere eines Ofens sowie eine Kühleinrichtung 11 angeordnet sind. In dem Raum zwischen der Platte 60 und der Kühleinrichtung 11 ist eine Auflage in Form eines Rahmens 3a angeordnet, der in diesem Ausführungsbeispiel entsprechend den am Rahmen 3a angetragenen Pfeilen sowohl in der Ebene der Längserstreckung des Raumes zwischen der Platte 60 und der Kühleinrichtung 11 als auch in der Ebene senkrecht dazu, d.h. in der Höhe verstellbar ist, so daß der Abstand des Rahmens 3a zur Platte 60 und zur Kühleinrichtung 11 verändert werden kann. Damit kann der Wärmeeintrag in den Halbleiter-Wafer 10 beim Aufheizen sowie Abkühlen des Halbleiter-Wafers 10 nach einer vorgebbaren Sollkurve durch eine Höhenverstellung des Rahmens 3a zwischen der Wärmequelle 6 und der Kühleinrichtung 11 variiert bzw. konstantgehalten werden.

Die Längsverschiebung des Rahmens 3a dient im wesentlichen dazu, einen in den Rahmen 3a einlegbaren Halbleiter-Wafer 10 gemäß Figur 2b in die Vorrichtung zur Herstellung elektrisch leitfähiger Durchgänge mittels Thermomigration einzuschieben bzw. den Halbleiter-Wafer zu entnehmen.

Alternativ zu der in Figur 2a dargestellten Anordnung einer Vorrichtung zur Herstellung elektrisch leitfähiger Durchgänge mittels Thermomigration kann die Auflage 3a für den Halbleiter-Wafer 10 beispielsweise nur in Längsrichtung zur Zufuhr und Entnahme des Halbleiter-Wafers verschiebbar sein, während die Platte 60 und/oder die Kühleinrichtung 11 höhenverstellbar sind, so daß der jeweilige Abstand zum Rahmen 3a verändert werden kann.

Die Platte 60 ist Teil eines nicht näher dargestellten Ofens, der zum Aufheizen der Platte 60 mittels elektrischer Widerstandsheizung, induktiver Heizeinrichtung, Elektronenstrahl-Heizung, Mikrowellenheizung und dgl. aufheizbar ist. Durch entsprechenden Energieeintrag in die der Auflage 3 bzw. dem Rahmen 3a abgewandte Oberfläche der Platte 60 durch Einschießen von Elektronen, Einkoppeln von Strahlung oder dgl. kann entsprechend Energie in die Platte 60 eingetragen werden, die wiederum für eine gleichmäßige Wärmeverteilung über die Gesamtfläche der Vorrichtung sorgt. Anstelle einer Platte 60 kann auch jede andere entsprechend geeignete Einrichtung zur gleichmäßigen Wärmeverteilung eingesetzt werden.

Durch die gleichmäßig aufgeheizte Platte 60 wird eine homogene Wärmeverteilung in der dem Halbleiter-Wafer 10 zugewandten Oberfläche sichergestellt. Da sich jede Inhomogenität der von der Wärmequelle abgegebenen Wärmestrahlung im Halbleiter-Wafer 10 abbildet, ist eine solche gleichmäßige Wärmeverteilung besonders vorteilhaft sowohl für die Herstellung elektrisch leitfähiger Durchgänge über die gesamte Fläche des Halbleiter-Wafers als auch zur Vermeidung eines Verbiegens des Halbleiter-Wafers bzw. der darauf befindlichen einzelnen Halbleiterelemente.

Um sicherzustellen, daß die von der Platte 60 abgegebene Wärmestrahlung im wesentlichen auf den in der Auflage 3a angeordneten Halbleiter-Wafer 10 gerichtet wird, ist der Ofen bzw. die Platte 60 mittels eines Vakuums thermisch isoliert, während der Wärmestrom in Richtung auf den in der Auflage 3a befindlichen Halbleiter-Wafer 10 mittels vorzugsweise eines inerten, gut wärmeleitenden Gases wie beispielsweise Wasserstoff oder Helium, insbesondere durch Helium optimiert wird. Bei einer derartigen Anordnung heizen sich die Wasserstoff- oder Helium-Gasteilchen an der heißen Platte 60 auf und werden in den Halbleiter-Wafer 10 eingetragen.

Da sich die erhitzte Platte 60 zur Wärmeisolierung und zur Lenkung der Wärmestrahlung auf den Halbleiter-Wafer im Vakuum befindet, ist es erforderlich, für ein Verdampfen von Teilchen, die zu Verunreinigungen im Halbleiter-Wafer führen würden, einen entsprechend inaktiven Werkstoff für die Platte 60 auszuwählen. Hierfür kommt in erster Linie Graphit mit einer Bornitrid-Beschichtung sowie eine Reinst-Keramikplatte in Frage, so daß entsprechende Reaktionen unterdrückt und der Prozeß der Thermomigration nicht durch Verunreinigungen beeinflußt wird.

Zur Kühlung des in der Auflage 3a eingelegten Halbleiter-Wafers 10 wird ein ebenfalls inertes Gas, insbesondere Helium, eingesetzt, um den für den Prozeß der Thermomigration optimalen Temperaturbereich an der Unterseite des Halbleiter-Wafers 10 einzustellen. Zur getrennten Steuerbarkeit der Temperatur auf der Oberfläche des Halbleiter-Wafers 10 und auf dessen Unterfläche wird vorzugsweise der Raum in Höhe des Rahmens 3a unterteilt, so daß sowohl der Gasdruck als auch die Strömungsgeschwindigkeit im Raum oberhalb des Rahmens 3a und unterhalb des Rahmens 3a getrennt eingestellt werden können. Die damit mögliche getrennte Temperatursteuerung schafft die Voraussetzung für einen optimalen Verlauf des Thermomigrationsprozesses, so daß elektrisch leitfähige Durchgänge im scheibenförmigen Halbleiter in minimaler Zeit ohne ein Verbiegen infolge thermischer Beanspruchung des Halbleiter-Wafers geschaffen werden.

Eine typische Wärmeverteilung in der Vorrichtung gemäß Figur 2a weist eine Plattentemperatur von $T_1 = 1800°C$, eine Temperatur an der der Platte 60 zugewandten Oberfläche des Halbleiter-Wafers 10 von $T_2 = 1050°C$ sowie eine Temperatur von $T_3 = 20°C$ an der Oberfläche der Kühleinrichtung 11 auf.

Durch Veränderung des Abstandes $a_1$ zwischen der Platte 60 und dem Rahmen 3a bzw. des Abstandes $a_2$ zwischen dem Rahmen 3a und der Kühleinrichtung 11 sowie durch entsprechende Steuerung des Gasdruckes und der Strömungsgeschwindigkeit des Gases im Raum oberhalb und/oder unterhalb des Rahmens 3a kann die Erwärmung des auf dem Rahmen 3a befindlichen Halbleiter-Wafers 10 gesteuert werden. Ein bevorzugter Abstand zwischen der Oberfläche des Halbleiter-Wafers 10 und der Unterseite der Platte 60 beträgt

$a_1 = 0{,}3$ mm.

Ein bevorzugter Abstand zwischen der Unterseite des Halbleiter-Wafers 10 und der Kühleinrichtung 11 beträgt

$a_2 = 0{,}2$ bis $0{,}5$ mm

während im Bereich oberhalb des Halbleiter-Wafers ein Gasdruck von ca. 0,1 bis 30 mbar eingestellt wird.

Da der Wärmewiderstand des Halbleiter-Wafers 10 sehr klein gegenüber dem Wärmewiderstand der angrenzenden Gasschichten ist, kann die Temperatur $T_2$ an der Oberfläche des Halbleiter-Wafers durch die Näherungsgleichung

$$T_2 = \frac{a_2}{a_1 + a_2} * (T_1 - T_3)$$

bestimmt werden, wobei $T_1$ die Plattentemperatur und $T_3$ die Temperatur der Kühleinrichtung ist.

Figur 2c zeigt einen schematischen Querschnitt durch eine alternative Vorrichtung, in der anstelle eines zwischen der Wärmequelle 60 und der Kühleinrichtung 11 angeordneten Rahmens 3a zur Aufnahme eines Halbleiterelements 10, beispielsweise in Form eines Silizium-Wafers, die Auflage aus Stiften oder Stegen 3c besteht, die auf der Kühleinrichtung 11 abgestützt bzw. in der Kühleinrichtung 11 geführt sind, so daß der Abstand des auf den Stiften oder Stegen 3c aufliegenden Halbleiter-Wafers 10 zur Kühleinrichtung 11 und dementsprechend zur Wärmequelle 6 verändert werden kann. Damit kann auch bei dieser Anordnung der Wärmeeintrag in den Halbleiter-Wafer 10 beim Aufheizen sowie Abkühlen des Halbleiter-Wafers 10 nach einer vorgebbaren Sollkurve verändert werden. Die eingetragene Wärmestrahlung W wirkt auf die der Wärmequelle zugewandte Oberfläche des Halbleiter-Wafers 10, durchdringt diesen und wird zur Kühleinrichtung 11 weitergeleitet.

Die in den Figur 2a und 2c schematisch dargestellten Vorrichtungen zur Herstellung elektrisch leitfähiger Durchgänge in scheibenförmigen Halbleitern mittels Thermomigration erweisen sich als besonders energieeffizient und optimal bezüglich des Thermomigrationsprozesses.

Eine in Figur 2d detailliert dargestellte Vorrichtung zur Herstellung von Durchgängen durch scheibenförmige Halbleiter mittels Thermomigration besteht aus einem in einem Maschinenrahmen 20 angeordneten Probenbehälter 2, der sich aus einem beweglichen Probenstempel 3, einem ortsfesten Rezipienten 4 und einem ebenfalls ortsfesten Außenmantel 5 zusammensetzt. Der Probenstempel 3 ist in Richtung des Doppelpfeils X auf einer Führungsschiene 201 von einer Beladestellung zu einer unterhalb einer Behandlungsstellung angeordneten Stellung bewegbar. Mittels einer Führungsvorrichtung 202 kann der Probenstempel 3 in Richtung des Doppelpfeils Z von der unterhalb der Behandlungsstellung befindlichen Stellung in die Behandlungsstellung über eine Hubhöhe H verfahren werden. Eine Aufnahmevorrichtung 203 für Gaszuführungsleitungen, Kühlleitungen, Meßkabel und dgl. ist mit dem den Probenstempel 3 aufnehmenden Schlitten 204 verbunden.

Die Oberseite des Rezipienten 4 ist in einer Lichtaustrittsblende 14 gelagert, die den Probenbehälter 2 unterhalb einer Wärmequelle 6 zentriert, die vorzugsweise aus zwei gekreuzten Halogenlampenfeldern 61, 62 besteht. Die gekreuzten Halogenlampenfelder 61, 62 weisen eine Vielzahl einzeln ansteuerbarer Halogenlampen auf, so daß eine homogene Wärmestrahlung auf die der Wärmequelle 6 zugewandte Oberfläche des Halbleiter-Wafers 10 gewährleistet wird. Durch den regelbaren Temperaturverlauf über die Halbleiter-Waferoberfläche besteht die Möglichkeit, die Temperatur zum Rand der Wafer-Oberfläche hin anzuheben, so daß ein individuelles Temperaturprofil über die Wafer-Oberfläche eingestellt werden kann. Diese Einstellbarkeit der Lichtstimmung, d.h. der Leistungsverteilung zur Temperaturhomogenisierung, gewährleistet gleiche Verhältnisse über die gesamte Oberfläche des Halbleiter-Wafers, so daß mittels eines speziellen Temperatur-Meßverfahrens optimale Bedingungen zur Thermomigration eingestellt werden können.

Oberhalb der Wärmequelle 6 ist ein Spiegelreflektor 13 angeordnet, der zusammen mit der Wärmequelle 6 und der Lichtaustrittsblende 14 über eine Halterung 15 mit dem Maschinenrahmen 20 verbunden ist.

Ein aus einem 3-Punkt-Hubteller 37 und einem Führungs-Hubteller 38 zusammengesetzter Hubteller dichtet den Probenstempel 3 zur Unterseite ab, wobei der 3-Punkt-Hubteller 37 eine gleichmäßige Anlage zum gasdichten Abschluß des Probenstempels 3 aufweist.

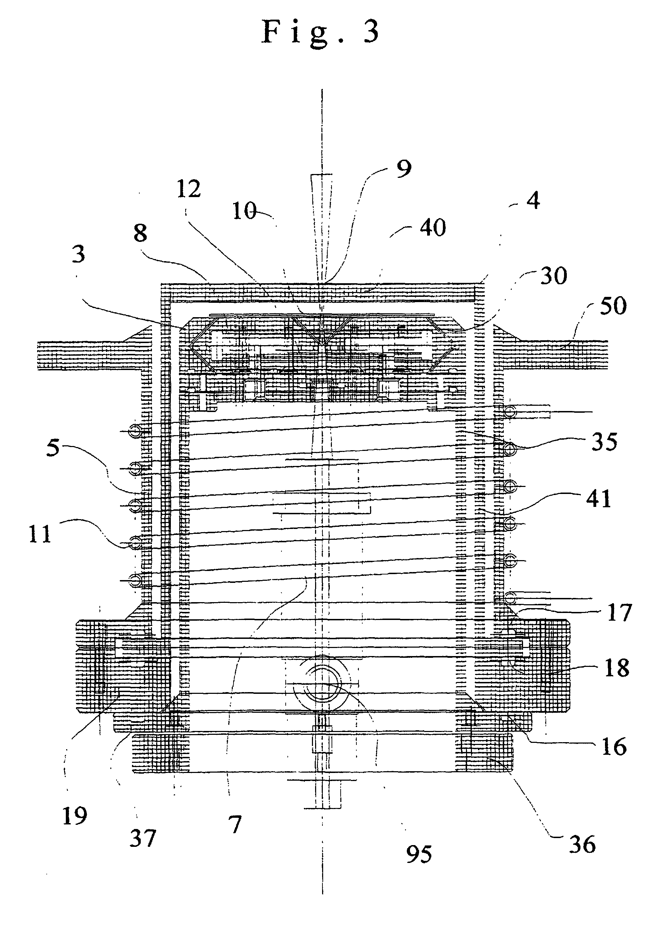

Figur 3 zeigt einen Längsschnitt durch den Probenbehälter 2 mit einem darin angeordneten Pyrometer-Meßkopf 7.

Der Probenbehälter 2 setzt sich aus dem äußeren, mittels eines Kühlrohres 11 gekühlten Außenmantel 5 und dem mit diesem über eine Dichtung 17 verbundenen Rezipienten oder Probenaufnahmezylinder 4 sowie dem beweglichen Probenstempel 3 zusammen. Der Rezipient 4 und der Außenmantel 5 sind über eine weitere Dichtung 18 mit einem Befestigungsring 19 verbunden und über einen deckseitigen Flansch 50 des Außenmantels 5 an der Lichtaustrittsblende 14 gemäß Figur 2d befestigt.

In der in Figur 3 dargestellten Arbeitsstellung mit vollständig in den Rezipienten 4 eingefahrenen Probenstempel 3 liegt dieser mit einem unteren Probenflansch 36 über eine Gasdichtung 16 gasdicht am Befestigungsring 19 an.

Der Rezipient 4 weist auf seiner Oberseite eine Strahlendurchtrittsfläche 40 auf, durch die die von den Halogenlampenfeldern 61, 62 der Wärmequelle 6 abgegebene Strahlung auf einen Probenkopf 30 an der Oberseite des Probenstempels 3 gelangt. Auf dem Probenkopf 30 ist eine nicht näher bezeichnete Probenaufnahme zur Lagerung des zu bearbeitenden Halbleiter-Wafers 10 vorgesehen. Durch eine Drei-Punkt-Spitzenlagerung wird eine äquidistante Lagerung des Halbleiter-Wafers 10 zur Oberfläche des Probenkopfes 30 mit einer Genauigkeit von 200 bis 300 μm gewährleistet.

Die Strahlendurchtrittsfläche 40 des Rezipienten 4 weist eine große optische Homogenität und bei vorgegebener Wellenlänge eine hohe Transmissionsfähigkeit auf und besteht vorzugsweise aus Quarz oder Saphir.

Zentrisch innerhalb eines Probenzylinders 35 des Probenstempels 3 ist ein Pyrometer-Meßkopf 7 angeordnet, der über einen Temperaturmeß- und Gaskanal 9 sowie ein im Temperaturmeß- und Gaskanal 9 befindliches Meßfenster 12 auf die dem Probenkopf 30 bzw. der Probenaufnahme zugewandte Oberfläche des Halbleiter-Wafers 10 gerichtet ist. Der Pyrometer-Meßkopf 7 mit einer bevorzugten Wellenlänge von 2,2 μm weist einen fein einstellbaren Fokuskegel auf, der einen nur kleinen Fleck auf dem Halbleiter-Wafer 10 erfaßt, so daß infolge der Temperaturmessung keine wesentliche Störung zwischen dem Halbleiter-Wafer 10 und dem Probenkopf 30 auftritt. Dieser Meßfleck ist repräsentativ für die Temperatur auf dem gesamten Halbleiter-Wafer 10, da - wie vorstehend in Verbindung mit Figur 2d ausgeführt wurde - die Leistungsverteilung über die Oberfläche des Halbleiter-Wafers 10 mittels der individuell steuerbaren Halogenlampen des gekreuzten Halogenlampenfeldes 61, 62 der Wärmequelle 6 einstellbar ist.

Das Meßfenster 12 besteht vorzugsweise aus Saphir ($Al_2O_3$), das einem Quarzfenster vorgezogen wird, da es bis in den weiten infraroten Wellenbereich offen ist.

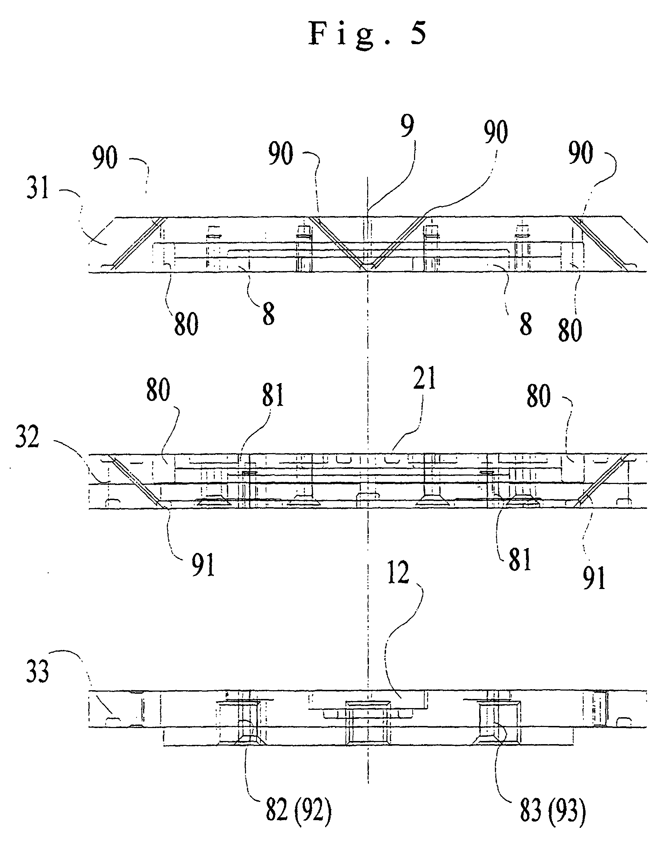

Der Probenkopf 30 weist gemäß Figur 5 drei Kopfebenen 31, 32, 33 auf, von denen die Probenaufnahme mit der ersten Probenkopfebene 31 verbunden ist. Die erste Probenkopfebene 31 des Probenkopfes 30 weist den zentralen Temperaturmeßund Gaskanal 9 sowie mehrere radial verteilte, diagonal durch die erste Probenkopfebene 31 geführte Gaskanäle 90 auf, durch die ein gut wärmeleitendes Gas wie Helium oder Wasserstoff geleitet und über die düsenförmigen Öffnungen der Kanäle 9 bzw. 90 austritt und unter den Halbleiter-Wafer 10 strömt. Die Gaszufuhr dient der Reinhaltung des Prozeßraumes, wobei der Durchfluß vorzugsweise mit 0,5 bis 50 mbar/l Gasstrom so eingestellt wird, daß der Halbleiter-Wafer 10 durch den Gasstrom nicht angehoben wird und keine Inhomogenitäten auftreten. Die Abfuhr des Prozeßgases erfolgt über eine Öffnung 95 im Sockelbereich des Probenzylinders 35.

Die zweite Probenkopfebene 32 des Probenkopfes 30 weist diagonale Gaskanäle 91, den zentralen Temperaturmeß- und Gaskanal 9 und Kühlwasserkanäle 81 auf, die zu Kühlelementen 8 führen, die zur Vergrößerung der wärmeaufnehmenden Fläche Ausnehmungen 80 enthalten. Die Verbindung zwischen der ersten Probenkopfebene 31 und der zweiten Probenkopfebene 32 erfolgt mittels flüssigkeitsdichter Dichtungsringe sowie gasdichter Außenringe, die in entsprechende Öffnungen an den einander zugewandten Oberflächen der ersten und zweiten Probenkopfebene 31, 32 des Probenkopfes 30 angeordnet sind.

Die dritte Probenkopfebene 33 des Probenkopfes 30 weist einen Kühlflüssigkeitseinlaß 82 und einen Kühlflüssigkeitsauslaß 83 bzw. bei Drehung der dritten Probenkopfebene 33 um 90° einen entsprechenden Gaseinlaß 92 und Gasauslaß 93 für das Prozeßgas auf. Zentrisch in die dritte Probenkopfebene 33 des Probenkopfes 30 eingelassen ist das Meßfenster 12, das sich im optischen Temperaturmeßkanal 9 befindet.

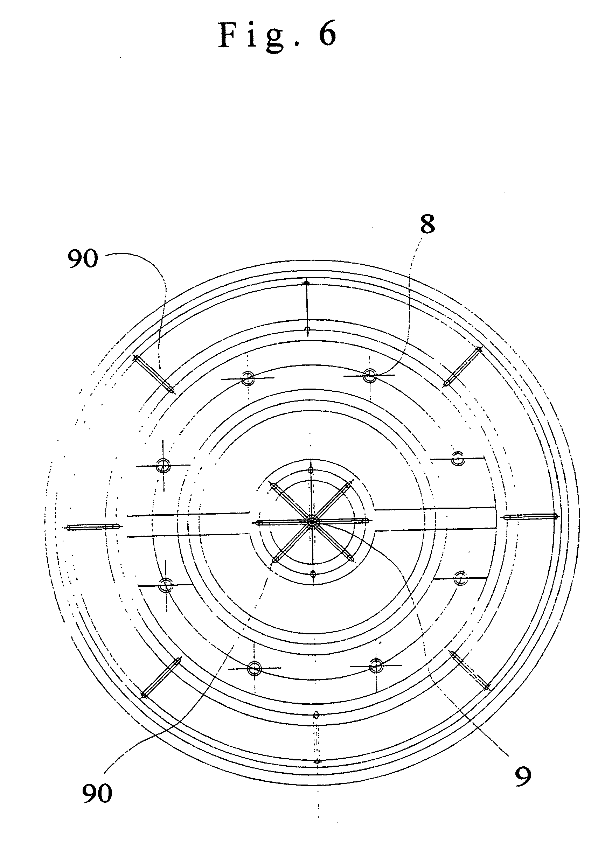

Eine in Figur 6 dargestellte Draufsicht auf die erste Probenkopfebene 31 verdeutlicht die Anordnung der Gas- und Kühlflüssigkeitskanäle sowie der Meßöffnung 9 zur Erfassung der Wafer-Temperatur. Die drei Probenkopfebenen 31 bis 33 werden vorzugsweise aus Reinstaluminium hergestellt.

Das in Figur 3 spiralförmig um den Außenmantel 5 gelegte Kühlrohr 11a bewirkt ein Abkühlen des Probenbehälters 2 von der der Wärmequelle 6 zugewandten Oberseite bis zum sockelseitigen Dichtungsbereich, damit die Funktionsfähigkeit der Dichtungen zwischen dem Außenmantel 5, dem Rezipienten 4 und dem Probenstempel 3 gewährleistet ist.

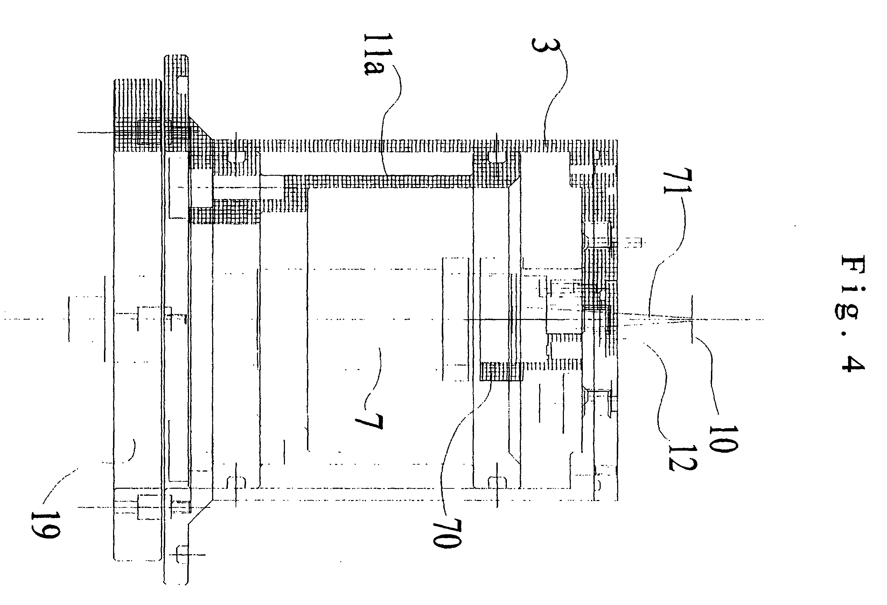

Eine andere Ausführungsform der Kühlung ist in Figur 4 dargestellt, bei der ein Kühlzylinder 11a im Innern des Probenstempels 3 so angeordnet ist, daß sich ein Hohlraum zur Aufnahme von Kühlflüssigkeit hohlzylinderförmig innerhalb des Probenstempels 3 erstreckt. Eine weitere Variante besteht darin, sowohl eine äußere Kühlschlangen-Kühlung gemäß Figur 3 mit einer inneren Kühizylinder-Kühlung gemäß Figur 4 zu kombinieren.

Der Pyrometer-Meßkopf 7 ist mittels eines Pyrometerflansches 70 am Probenstempel 3 fixiert und kann entsprechend justiert werden. Der Fokuskegel 71 des Pyrometer-Meßkopfes 7 ist so auf die Oberfläche des Halbleiter-Wafers 10 gerichtet, daß sich ein kleiner Meßfleck in der Mitte des Halbleiter-Wafers 10 ergibt, wo kein Halbleiter-Bauelement angeordnet ist.

Mit der vorstehend beschriebenen Thermomigrationsvorrichtung wird ein hochgenau steuerbarer Wärmetransport durch den Halbleiter-Wafer 10 von der den gekreuzten Halogenlampenfelder 61, 62 der Wärmequelle 6 zugewandten Rückseite des Halbleiter-Wafers 10 zu der dem gekühlten Probenkopf 30 zugewandten Oberseite des Halbleiter-Wafers 10 gewährleistet. Bei dieser über die gesamte Fläche des Halbleiter-Wafers 10 einstellbare Temperaturdifferenz von ungefähr 2°C bis 10°C bei einer Dicke des Halbleiter-Wafers von ca. 300 $\mu$m wandert ein auf der kühleren Oberfläche des Halbleiter-Wafers 10 bzw. der auf dem Halbleiter-Wafer angeordneten Halbleiterbauelemente angebrachtes, elektrisch leitendes (Aluminium) Tröpfchen mit einer Dicke von ca. 2 bis 3 $\mu$m zur gegenüberliegenden, wärmeren Oberfläche des Halbleiterwafers 10 und bewirkt damit die gewünschte leitende Verbindung zwischen den gegenüberliegenden Oberflächen des Halbleiter-Wafers bzw. der Halbleiter-Bauelemente an den vorgesehenen Verbindungsstellen.

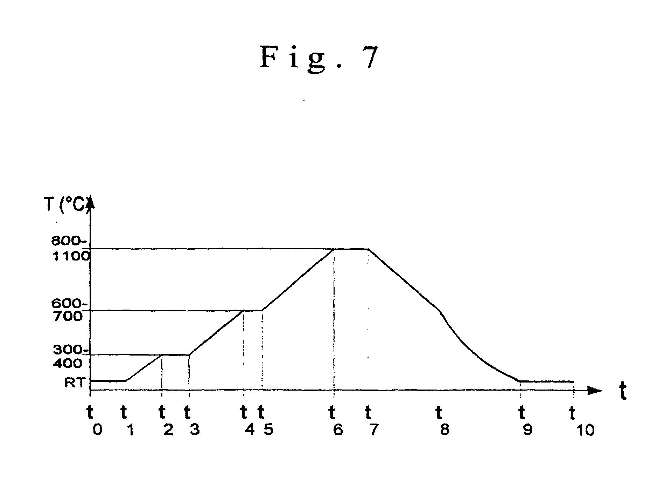

Figur 7 verdeutlicht eine Ausführungsform des erfindungsgemäßen Verfahren zur Herstellung elektrisch, leitender Verbindungen zwischen den gegenüberliegenden Oberflächen eines Halbleiter-Wafers mittels Thermomigration, wobei das in Figur 7 dargestellte Verfahren verschiedenartig modifizierbar ist.

Zu Beginn des Prozesses wird zum Zeitpunkt $t_0$ der Probenstempel 3 mit dem Probenkopf 30 aus dem Rezipienten 4 bzw. dem Außenmantel 5 in Richtung des Pfeiles Z gemäß Figur 2d herausgefahren und zum Beladepunkt bewegt. Nach dem Auflegen eines Halbleiter-Wafers 10 auf die Probenaufnahme des Probenkopfes 30 wird der Probenstempel 3 zunächst in X-Richtung und anschließend in Z-Richtung gemäß Figur 2d in die Behandlungsstellung bewegt, d. h. in den Rezipienten 4 eingefahren und das System geschlossen. Anschließend wird der Probenstempel 3 evakuiert und in einer Spülphase Helium zum Spülen in den Probenstempel 3 eingelassen. Das Einlassen von Kühlwasser in den Probenstempel 3 beendet zum Zeitpunkt $t_1$ die Vorbereitungsphase.

Daran anschließend wird die Probe durch Zuschalten der Wärmequelle 6 mit einer Temperatursteigerung von ca. 30°C/Sekunde bis zum Zeitpunkt $t_2$ auf eine Temperatur von ca. 300°C bis 400° C aufgeheizt. Bei dieser Temperatur erfolgt ein erneutes Reinigen (Helium-Spülen) der Probenatmosphäre über eine Zeitdauer von ca. 1 min. bis zum Zeitpunkt $t_3$. Anschließend erfolgt ein weiteres Aufheizen der Probe bis auf eine Temperatur von ca. 600°C bis 670°C (Zeitpunkt $t_4$), bei der das auf die Oberfläche des Halbleiter-Wafers 10 aufgebrachte Aluminiumtröpfchen mit dem halbleitenden Grundkörper durch Tröpfchenbildung reagiert (Zeitpunkt $t_5$). Anschließend wird die Probe weiter bis auf eine Arbeitstemperatur von ca. 800°C bis 1100°C aufgeheizt, bei der der Migrationsprozeß abläuft, d. h. das Aluminiumtröpfchen wandert durch den halbleitenden Grundkörper der auf dem Halbleiter-Wafer angeordneten Halbleiterbauelemente.

Die Migrationsgeschwindigkeit ist dabei proportional zum Temperaturgradienten und der Arbeitstemperatur und bestimmt die Zeitdauer der Thermomigration ($t_6$ bis $t_7$). Nach Beendigung des Migrationsprozeßes wird die Probentemperatur rampenförmig mit einer Temperaturabnahme von ca. 30°C pro Sekunde abgesenkt. Bei einer Temperatur von ca. 650°C (Zeitpunkt $t_8$) wird die Probe der freien Abkühlung überlassen, so daß die Probentemperatur in einer Zeitspanne von ca. 2 bis 3 min. (Zeitpunkt $t_9$) heruntergefahren wird.

Daran schließt sich das Herausfahren des Probenstempels 3 aus dem Rezipienten 4, die Bewegung des Probenstempels 3 zum Beladepunkt, das Abnehmen des Halbleiter-Wafers und Ablage in beispielsweise einem stickstoffumströmten Magazin an.

**Bezugszeichenliste**

| 1 | Halbleiter-Bauelement | 100 | Halbleiter-Grundkörper (n-leitende Schicht) |
|---|---|---|---|

(fortgesetzt)

|  |  | 101 | Halbleiter-Grundkörper (p-leitende Schicht) |
|  |  | 102 | Raumladungszone |
|  |  | 103 | niederohmiger, stark dotierter Bereich |
|  |  | 104 | Oberflächenbereich |
|  |  | 105 | rückseitige Oberfläche |
|  |  | 106 | Elektrode |
|  |  | 106a | Kontaktstelle |
|  |  | 107 | Elektrode |
|  |  | 107a | Kontaktstelle |
|  |  | 108 | Antireflexionsschicht |
|  |  | 109 | isolierende Schicht |
|  |  | 110 | isolierende Schicht |
|  |  | 111 | (halb)leitender Kanal |
| 2 | Probenbehälter |  |  |
| 3 | Auflage | 3a | Rahmen |
|  |  | 3b | Probenstempel |
|  |  | 3c | Stege, Stifte |
|  |  | 30 | Probenkopf |
|  |  | 31 | 1. Probenkopfebene |
|  |  | 32 | 2. Probenkopfebene |
|  |  | 33 | 3. Probenkopfebene |
|  |  | 35 | Probenzylinder |
|  |  | 36 | Probenflansch |
|  |  | 37 | 3-Punkt-Hubteller |
|  |  | 38 | Führungs-Hubteller |
| 4 | Rezipient | 40 | Strahlendurchtrittsfläche |
|  |  | 41 | Quarzzylinder |
| 5 | Außenmantel | 50 | Außenmantel-Flansch |
| 6 | Wärmequelle | 60 | Platte |
|  |  | 61 | 1. Halogenlampenebene |
|  |  | 62 | 2. Halogenlampenebene |
| 7 | Pyrometer-Meßkopf | 70 | Pyrometerflansch |
|  |  | 71 | Fokuskegel |
| 8 | Flüssigkeitskühlung | 80 | Kühlkammer |
|  |  | 81 | Kühlkanal |
|  |  | 82 | Kühlflüssigkeits-Einlaß |
|  |  | 83 | Kühlflüssigkeits-Auslaß |
| 9 | Temperaturmeß- und Gaskanal | 90 | Gasaustrittsdüsen |
|  |  | 91 | Gaskanäle |
|  |  | 92 | Gaseinlaß |
|  |  | 93 | Gasauslaß |
|  |  | 95 | Gasabfuhr |

(fortgesetzt)

| 10 | Halbleiter(-Wafer) | | |
|----|--------------------|------|----------------|
| 11 | Kühleinrichtung | 11a | Kühlrohr |
| | | 11b | Kühlzylinder |
| 12 | Meßfenster | | |
| 13 | Spiegelreflektor | | |
| 14 | Lichtaustrittsblende | | |
| 15 | Halterung | | |
| 16 | Gasdichtung | | |
| 17 | Dichtung | | |
| 18 | Dichtung | | |
| 19 | Befestigungsring | | |
| 20 | Maschinenrahmen | 201 | Horizontalführung |
| | | 202 | Vertikalführung |
| | | 203 | Leitungsaufnahme |
| 21 | Dichtungsringe | | |
| 25 | Gestell | | |

## Patentansprüche

1.  Verfahren zur Herstellung elektrisch leitfähiger Durchgänge in einem scheibenförmigen Halbleiter mittels Thermomigration durch Erzeugen eines Temperaturgradienten zwischen zwei entgegengesetzten Oberflächen des Halbleiters (10), wobei die erste Oberfläche gleichmäßig über die Oberfläche verteilt bis auf eine Arbeitstemperatur des Thermomigrationsprozesses von 800°C bis 1100°C erwärmt und anschließend bis auf eine Entnahmetemperatur abgesenkt wird und auf die zweite Oberfläche ein leitfähiger Dotierungsstoff aufgebracht und die zweite Oberfläche gleichmäßig über die Oberfläche verteilt gekühlt wird,
    **dadurch gekennzeichnet,**
    **daß** die erste Oberfläche einen ersten Abstand (a1) zu einer Wärmequelle (6) und die zweite Oberfläche einen zweiten Abstand (a2) zu einer Kühleinrichtung (11) aufweist und die Gesamtleistung des Wärmeeintrags in den Halbleiter (10) und/oder die Leistungsverteilung des Wärmeeintrags über die zu erwärmende Oberfläche des Halbleiters (10) in Abhängigkeit von der an mindestens einem Temperatur-Meßpunkt auf dem Halbleiter (10) gemessenen Temperatur durch Veränderung des ersten und zweiten Abstandes (al, a2) eingestellt wird.

2.  Verfahren nach Anspruch 1, **dadurch gekennzeichnet, daß** der Halbleiter (10) in einem geschlossenen, mit einem gut wärmeleitenden, inertgasgefüllten System (2, 3) angeordnet wird.

3.  Verfahren nach Anspruch 2, **dadurch gekennzeichnet, daß** das Inertgas aus Wasserstoff oder Helium besteht.

4.  Verfahren nach mindestens einem der vorangehenden Ansprüche, **dadurch gekennzeichnet, daß** der Halbleiter (10) senkrecht zur der Ebene zwischen Wärmequelle und Kühleinrichtung zu bewegen ist.

5.  Verfahren nach mindestens einem der vorangehenden Ansprüche, **dadurch gekennzeichnet, daß** die Oberflächen des Halbleiters (10) in voneinander getrennten Räumen angeordnet werden.

6. Verfahren nach mindestens einem der vorangehenden Ansprüche, **dadurch gekennzeichnet, daß** die Wärmestrahlung im wesentlichen senkrecht auf die zu erwärmende Oberfläche des Halbleiters (10) auftrifft.

7. Verfahren nach mindestens einem der vorangehenden Ansprüche, **dadurch gekennzeichnet, daß** der Halbleiter (10) auf einem in mindestens einer Ebene beweglichen Probenstempel (3) angeordnet wird, der zwischen einer Beschickungs- und einer Bestrahlungsposition bewegt wird.

8. Verfahren nach mindestens einem der vorangehenden Ansprüche, **dadurch gekennzeichnet, daß** die Temperatur des Halbleiters (10) mit einer pyrometrischen Meßeinrichtung (7) über einen optischen Meßkanal (9) berührungsfrei gemessen wird.

9. Verfahren nach mindestens einem der vorangehenden Ansprüche, **dadurch gekennzeichnet, daß** die Aufheizung des Halbleiters (10) mit einem Temperaturanstieg kleiner oder gleich 30 K/Sekunde erfolgt, anschließend die Temperatur konstant gehalten wird, bis der Thermomigrationsprozess abgeschlossen ist, in einer ersten Abkühlphase mit abnehmender Wärmestrahlung abgekühlt und anschließend über eine vorgegebene Zeitspanne in freier Abkühlung bis zur Entnahmetemperatur abgekühlt wird.

10. Verfahren nach Anspruch 9, **dadurch gekennzeichnet, daß** die Aufheizung und Abkühlung des Halbleiters (10) nach einer Rampenfunktion erfolgt.

11. Verfahren nach mindestens einem der vorangehenden Ansprüche, **dadurch gekennzeichnet, daß** der Halbleiter (10) bis zu einer ersten vorgegebenen Temperatur von 300°C bis 400°C aufgeheizt wird, daß nach dem Erreichen dieser Temperatur des Halbleiters (10) der den Halbleiter (10) umgebende Raum über eine vorgegebene Zeitspanne gereinigt wird, daß der Halbleiter (10) auf eine zweite vorgegebene Temperatur von ca. 600°C bis 700°C weiter erhitzt wird, bei der der leitfähige Dotierungsstoff mit dem halbleitenden Grundkörper des Halbleiters durch Tröpfchenbildung reagiert, und daß anschließend auf die Arbeitstemperatur des Migrationsprozesses von ca. 900°C bis 1100°C aufgeheizt wird, daß nach Beendigung des Thermomigrationsprozesses die Temperatur des Halbleiters (10) bis zu einer dritten vorgegebenen Temperatur von ca. 650°C abgesenkt und anschließend der Halbleiter (10) über eine Zeitspanne von ca. zwei bis drei Minuten auf eine vorgegebene Entnahmetemperatur abgekühlt wird.

12. Verfahren nach mindestens einem der Ansprüche 7 bis 11, **dadurch gekennzeichnet, daß** der Probenstempel (3) in eine Entnahme- und Beschickungsposition gefahren und zur Aufnahme des Halbleiters (10) geöffnet wird, daß der Probenstempel (3) nach dem Beschicken des Halbleiters (10) in eine geschlossene Position gebracht und der Probenstempel (3) evakuiert und mit einem Inertgas gespült wird, daß eine Kühlflüssigkeit in den Probenstempel (3) eingelassen und der Halbleiter (10) nach dem vorgegebenen Programm aufgeheizt und abgekühlt wird, daß der Probenstempel (3) erneut in die Entnahme- und Beschickungsposition gefahren und der Halbleiter (10) entnommen und in ein mit Stickstoff umspültes Magazin angeordnet wird.

13. Vorrichtung zur Herstellung elektrisch leitfähiger Durchgänge in einem scheibenförmigen Halbleiter mittels Thermomigration durch Erzeugen eines Temperaturgradienten zwischen zwei entgegengesetzten Oberflächen des Halbleiters, von denen eine Oberfläche einer Wärmequelle (6) und die andere Oberfläche einer Kühleinrichtung (11) zugewandt ist, und Aufbringen eines leitfähigen Dotierungsstoffes auf die der Wärmequelle (6) zugewandten Oberfläche mit einer zwischen der Wärmequelle (6) und der Kühleinrichtung (11) angeordnete Auflage zur Aufnahme des Halbleiters, wobei die Wärmequelle (6) eine homogene Wärmestrahlung an die ihr zugewandte Oberfläche des Halbleiters (10) abgibt,
**dadurch gekennzeichnet**
**daß** die Vorrichtung einen Pyrometermeßkopf (7) zur Messung der Oberflächentemperatur des Halbleiters (10) aufweist und der Abstand zwischen der Auflage (3) und der Wärmequelle (6) und/oder zwischen der Auflage (3) und der Kühleinrichtung (11) in Abhängigkeit von der gemessenen Oberflächentemperatur veränderbar ist.

14. Vorrichtung nach Anspruch 13, **dadurch gekennzeichnet, daß** der Raum zwischen der Wärmequelle (6) und der Kühleinrichtung (11) gekapselt und mit einem inerten, gut wärmeleitenden Gas gefüllt ist.

15. Vorrichtung nach Anspruch 14, **dadurch gekennzeichnet, daß** es sich bei dem Gas um Wasserstoff oder Helium handelt.

**16.** Vorrichtung nach Anspruch 14 oder 15, **dadurch gekennzeichnet, daß** der Raum' in der Ebene der Auflage (3) unterteilt ist.

**17.** Vorrichtung nach einem der Ansprüche 14 bis 16, **dadurch gekennzeichnet, daß** der Gasdruck und/oder die Gasströmung in dem Raum bzw. den Räumen veränderbar ist.

**18.** Vorrichtung nach einem der vorangehenden Ansprüche 13 bis 17, **dadurch gekennzeichnet, daß** die Wärmequelle (6) aus einem direkt oder indirekt beheizten Ofen besteht.

**19.** Vorrichtung nach Anspruch 18, **dadurch gekennzeichnet, daß** der Ofen eine im wesentlichen der Fläche der Auflage (3) entsprechende Platte (60) aufweist, die mittels elektrischer Widerstandsheizung, induktiver Heizung, Elektronenstrahl-Heizung oder mittels Mikrowellenheizung aufheizbar ist.

**20.** Vorrichtung nach Anspruch 19, **dadurch gekennzeichnet, daß** die Platte (60) aus einem pyrolytisch mit Bornitrid versiegeltem Graphitmaterial besteht.

**21.** Vorrichtung nach Anspruch 19, **dadurch gekennzeichnet, daß** die Platte (60) aus Reinstkeramik besteht.

**22.** Vorrichtung nach Anspruch 13, **dadurch gekennzeichnet, daß** die Wärmequelle (6) aus einem Halogenlampenfeld (61 bzw. 62) besteht, das sich zumindest über die Fläche des Halbleiters (10) erstreckt.

**23.** Vorrichtung nach Anspruch 13 oder 22, **dadurch gekennzeichnet, daß** die Wärmequelle (6) aus in zwei Ebenen angeordneten, gekreuzten Halogenlampenfeldern (61, 62) besteht.

**24.** Vorrichtung nach mindestens einem der vorangehenden Ansprüche 13 bis 23, **dadurch gekennzeichnet, daß** ein Spiegelreflektor (13) auf der der Auflage (3) gegenüberliegenden Seite der Wärmequelle (6) angeordnet ist.

**25.** Vorrichtung nach mindestens einem der vorangehenden Ansprüche 13 bis 24, **dadurch gekennzeichnet, daß** die Auflage (3) aus einem Rahmen (3a) besteht, der in einer Ebene parallel zur Längserstreckung der Wärmequelle (6) beweglich ist.

**26.** Vorrichtung nach mindestens einem der vorangehenden Ansprüche 13 bis 24, **dadurch gekennzeichnet, daß** die Auflage (3) aus mit der Kühleinrichtung (8) verbundenen Stiften oder Stegen (3c) besteht, die die der Kühleinrichtung (8) zugewandte Oberfläche des Halbleiters (10) punkt- oder linienförmig abstützen.

**27.** Vorrichtung nach mindestens einem der vorangehenden Ansprüche 13 bis 26, **dadurch gekennzeichnet, daß** die Auflage (3) aus einem mit der Kühleinrichtung (11, 11a) verbundenen Probenstempel (3) besteht.

**28.** Vorrichtung nach Anspruch 27, **dadurch gekennzeichnet, daß** der Probenstempel (3) aus einem Probenzylinder (35), einem die Deckfläche des Probenzylinders (35) bildenden, den Halbleiter (10) aufnehmenden Probenkopf (30), einem an der Unterseite des Probenzylinders (35) nach außen abstehenden Probenflansch (36) und einem den Probenzylinder (35) zur Unterseite gasdicht abschließenden Hubteller (37, 38) besteht.

**29.** Vorrichtung nach Anspruch 28, **dadurch gekennzeichnet; daß** der Probenstempel (3) in axialer Richtung (Z-Richtung) in einen Rezipienten (4), der aus einer der Wärmequelle (6) zugewandten Strahlendurchtrittsfläche (40) und einem Quarzzylinder (41) besteht, ein- und ausfahrbar ist.

**30.** Vorrichtung nach Anspruch 29, **dadurch gekennzeichnet, daß** der Rezipient (4) von einem zylinderförmigen Außenmantel (5) umgeben ist, und daß der zylinderförmige Außenmantel (5) gekühlt und/oder innerhalb des Probenstempels (3) ein Kühlzylinder (11a) angeordnet ist.

**31.** Vorrichtung nach mindestens einem der Ansprüche 28 bis 30, **dadurch gekennzeichnet, daß** der Pyrometermeßkopf (7) zentrisch innerhalb des Probenzylinders (35) des Probenstempels (3) angeordnet ist und über einen Temperaturmeß- und Gaskanal (9) sowie ein im Temperaturmeß- und Gaskanal (9) befindliches Meßfenster (12) auf die dem Probenkopf (30) zugewandte Oberfläche des Halbleiters (10) gerichtet ist.

**32.** Vorrichtung nach Anspruch 31, **dadurch gekennzeichnet, daß** der Pyrometer-Meßkopf (7) einen fein einstellbaren Fokuskegel aufweist.

**33.** Vorrichtung nach Anspruch 31 oder 32, **dadurch gekennzeichnet, daß** der Pyrometer-Meßkopf (7) mit einer Wellenlänge von 2,2 μm arbeitet.

**34.** Vorrichtung nach Anspruch 31, 32 oder 33, **dadurch gekennzeichnet, daß** der Pyrometer-Meßkopf (7) mittels eines Pyrometerflansches (70) am Probenstempel (3) fixiert und justiert ist und daß der Fokuskegel (71) des Pyrometer-Meßkopfes (7) so auf die Oberfläche des Halbleiters (10) gerichtet ist, daß sich ein kleiner Meßfleck in der Mitte des Halbleiters (10) ergibt.

**35.** Vorrichtung nach Anspruch 34, **dadurch gekennzeichnet, daß** das Meßfenster (12) aus Saphir ($Al_2O_3$) besteht.

**36.** Vorrichtung nach mindestens einem der vorangehenden Ansprüche 13 bis 35', **dadurch gekennzeichnet, daß** der Probenkopf (30) drei Probenkopfebenen (31, 32, 33) ,aufweist, von denen die Aufnahme des Halbleiters (10) mit der ersten Probenkopfebene (31) verbunden ist, die den zentralen Temperaturmeß- und Gaskanal (9) sowie mehrere radial verteilte, diagonal durch die erste Probenkopfebene (31) geführte Gaskanäle (90) aufweist, durch die ein gut wärmeleitendes Gas geleitet und über düsenförmigen Öffnungen der Kanäle (9 bzw. 90) austritt, unter den Halbleiter (10) strömt und über eine Öffnung (95) im Sockelbereich des Probenzylinders (35) angeführt wird, daß die zweite Probenkopfebene (32) des Probenkopfes (30) diagonale Gaskanäle (91), den zentralen Temperaturmeß- und Gaskanal (9) und Kühlwasserkanäle (81) aufweist, die zu Kühlelementen (8) führen, und daß die dritte Probenkopfebene (33) des Probenkopfes (30) einen Kühlflüssigkeitseinlaß (82) und einen Kühlflüssigkeitsauslaß (83) sowie einen Gaseinlaß (92) und Gasauslaß (93) für das Prozeßgas aufweist, daß zentrisch in die dritte Probenkopfebene (33) des Probenkopfes (30) das sich im optischen Temperaturmeßkanal (9) befindende Meßfenster (12) eingelassen ist.

**37.** Vorrichtung nach Anspruch 36, **dadurch gekennzeichnet, daß** die drei Probenkopfebenen (31 bis 33) aus Reinstaluminium bestehen.

**Claims**

**1.** Method for producing electrically conductive passages in a semiconductor in wafer form by means of thermomigration, by producing a temperature gradient between two opposite surfaces of the semiconductor (10), the first surface being heated evenly over the surface to a working temperature of the thermomigration process of 800°C to 1100°C and then being reduced to a removal temperature, and a conductive dopant being applied to the second surface and the second surface being cooled evenly over the surface, **characterized in that** the first surface is at a first distance (a1) from a heat source (6) and the second surface is at a second distance (a2) from a cooling device (11), and the total power of the heat introduced into the semiconductor (10) and/or the distribution of the power of the heat introduced over the surface of the semiconductor (10) which is to be heated is set as a function of the temperature measured at at least one temperature measurement point on the semiconductor (10), by varying the first and second distances (a1, a2).

**2.** Method according to Claim 1, **characterized in that** the semiconductor (10) is arranged in a closed system (2, 3) which is filled with an inert gas of good thermal conductivity.

**3.** Method according to Claim 2, **characterized in that** the inert gas consists of hydrogen or helium.

**4.** Method according to at least one of the preceding claims, **characterized in that** the semiconductor (10) can be moved perpendicular to the plane between heat source and cooling device.

**5.** Method according to at least one of the preceding claims, **characterized in that** the surfaces of the semiconductor (10) are arranged in spaces which are separate from one another.

**6.** Method according to at least one of the preceding claims, **characterized in that** the thermal radiation impinges substantially perpendicularly on that surface of the semiconductor (10) which is to be heated.

**7.** Method according to at least one of the preceding claims, **characterized in that** the semiconductor (10) is arranged on a specimen ram (3) which can move in at least one plane and is moved between a loading position and an irradiation position.

8. Method according to at least one of the preceding claims, **characterized in that** the temperature of the semiconductor (10) is measured contactlessly using a pyrometric measuring device (7) via an optical measuring channel (9).

9. Method according to at least one of the preceding claims, **characterized in that** the semiconductor (10) is heated at a temperature increase rate of less than or equal to 30 K/second, then the temperature is kept constant until the thermomigration process has ended, is cooled in a first cooling phase with decreasing thermal radiation and is then cooled for a predetermined time under free cooling until it reaches the removal temperature.

10. Method according to Claim 9, **characterized in that** the heating and cooling of the semiconductor (10) takes place in accordance with a ramp function.

11. Method according to at least one of the preceding claims, **characterized in that** the semiconductor (10) is heated to a first predetermined temperature of 300°C to 400°C, **in that** after the semiconductor (10) has reached this temperature, the space which surrounds the semiconductor (10) is cleaned for a predetermined time, **in that** the semiconductor (10) is heated further to a second predetermined temperature of approx. 600°C to 700°C, at which the conductive dopant reacts with the semiconducting base body of the semiconductor through droplet formation, and **in that** heating is then continued to the working temperature of the migration process of approx. 900°C to 1100°C, **in that** after the thermomigration process has ended, the temperature of the semiconductor (10) is reduced to a third predetermined temperature of approx. 650°C, and then the semiconductor (10) is cooled to a predetermined removal temperature over a period of approx. two to three minutes.

12. Method according to at least one of Claims 7 to 11, **characterized in that** the specimen ram (3) is moved into a removal and loading position and is opened in order to receive the semiconductor (10), **in that** the specimen ram (3), after it has been loaded with the semiconductor (10), is moved into a closed position and the specimen ram (3) is evacuated and purged with an inert gas, **in that** a cooling liquid is admitted to the specimen ram (3) and the semiconductor (10) is heated and cooled in accordance with the predetermined programme, **in that** the specimen ram (3) is moved back into the removal and loading position and the semiconductor (10) is removed and arranged in a magazine around which nitrogen flushes.

13. Device for producing electrically conductive passages in a semiconductor in wafer form by means of thermomigration, by producing a temperature gradient between two opposite surfaces of the semiconductor, of which one surface faces a heat source (6) and the other surface faces a cooling device (11), and applying a conductive dopant to the surface which faces the heat source (6), with a support for receiving the semiconductor arranged between the heat source (6) and the cooling device (11), the heat source (6) releasing homogeneous thermal radiation to that surface of the semiconductor (10) which faces it, **characterized in that** the device has a pyrometer measuring head (7) for measuring the surface temperature of the semiconductor (10), and the distance between the support (3) and the heat source (6) and/or between the support (3) and the cooling device (11) can be varied as a function of the measured surface temperature.

14. Device according to Claim 13, **characterized in that** the space between the heat source (6) and the cooling device (11) is encapsulated and is filled with an inert gas of good thermal conductivity.

15. Device according to Claim 14, **characterized in that** the gas is hydrogen or helium.

16. Device according to Claim 14 or 15, **characterized in that** the space is divided in the plane of the support (3).

17. Device according to one of Claims 14 to 16, **characterized in that** the gas pressure and/or the gas flow in the space or spaces can be varied.

18. Device according to one of the preceding Claims 13 to 17, **characterized in that** the heat source (6) comprises a directly or indirectly heated furnace.

19. Device according to Claim 18, **characterized in that** the furnace has a plate (60) which substantially corresponds to the surface of the support (3) and can be heated by means of electrical resistance heating, inductive heating, electron beam heating or by means of microwave heating.

20. Device according to Claim 19, **characterized in that** the plate (60) consists of a graphite material which is pyrolytically sealed with boron nitride.

21. Device according to Claim 19, **characterized in that** the plate (60) consists of ultrapure ceramic.

22. Device according to Claim 13, **characterized in that** the heat source (6) comprises an array of halogen lamps (61 and 62), which extends at least over the area of the semiconductor (10).

23. Device according to Claim 13 or 22, **characterized in that** the heat source (6) comprises crossed halogen lamp arrays (61, 62) arranged in two planes.

24. Device according to at least one of the preceding Claims 13 to 23, **characterized in that** a mirror reflector (13) is arranged on the opposite side of the heat source (6) from the support (3).

25. Device according to at least one of the preceding Claims 13 to 24, **characterized in that** the support (3) comprises a frame (3a) which can move in a plane which is parallel to the longitudinal extent of the heat source (6).

26. Device according to at least one of the preceding Claims 13 to 24, **characterized in that** the support (3) comprises pins or webs (3c) which are connected to the cooling device (8) and support that surface of the semiconductor (10) which faces the cooling device (8) in punctiform or linear fashion.

27. Device according to at least one of the preceding Claims 13 to 26, **characterized in that** the support (3) comprises a specimen ram (3) which is connected to the cooling device (11, 11a).

28. Device according to Claim 27, **characterized in that** the specimen ram (3) comprises a specimen cylinder (35), a specimen head (30), which forms the top surface of the specimen cylinder (35) and receives the semiconductor (10), a specimen flange (36), which projects outwards at the underside of the specimen cylinder (35), and a lifting plate (37, 38), which seals off the specimen cylinder (35) in a gastight manner at the underside.

29. Device according to Claim 28, **characterized in that** the specimen ram (3) can be retracted and extended in the axial direction (Z direction) in a receptacle (4) which comprises a radiation-passage surface (40) facing the heat source (6) and a quartz cylinder (41).

30. Device according to Claim 29, **characterized in that** the receptacle (4) is surrounded by a cylindrical outer shell (5), and **in that** the cylindrical outer shell (5) is cooled and/or a cooling cylinder (11a) is arranged inside the specimen ram (3).

31. Device according to at least one of Claims 28 to 30, **characterized in that** the pyrometer measuring head (7) is arranged centrally inside the specimen cylinder (35) of the specimen ram (3) and is directed onto that surface of the semiconductor (10) which faces the specimen head (30), via a temperature-measuring and gas channel (9) and a measurement window (12) located in the temperature-measuring and gas channel (9).

32. Device according to Claim 31, **characterized in that** the pyrometer measuring head (7) has a finely adjustable focusing cone.

33. Device according to Claim 31 or 32, **characterized in that** the pyrometer measuring head (7) operates at a wavelength of 2.2 µm.

34. Device according to Claim 31, 32 or 33, **characterized in that** the pyrometer measuring head (7) is fixed to the specimen ram (3) and adjusted by means of a pyrometer flange (70), and **in that** the focusing cone (71) of the pyrometer measuring head (7) is directed onto the surface of the semiconductor (10) in such a way that a small measurement spot is formed in the centre of the semiconductor (10).

35. Device according to Claim 34, **characterized in that** the measurement window (12) consists of sapphire ($Al_2O_3$).

36. Device according to at least one of the preceding Claims 13 to 35, **characterized in that** the specimen head (30) has three specimen-head levels (31, 32, 33), of which the receiving part for the semiconductor (10) is connected to the first specimen-head level (31), which has the central temperature-measuring and gas channel (9) and a plurality of radially distributed gas channels (90) which lead diagonally through the first specimen-head level (31) and through which a gas of good thermal conductivity is passed, emerging via nozzle-like openings in the channels (9 and 90), flows beneath the semiconductor (10) and is guided onward via an opening (95) in the base region of the specimen cylinder (35),
**in that** the second specimen-head level (32) of the specimen head (30) has diagonal gas channels (91), the central temperature-measuring and gas channel (9) and cooling-water channels (81) which lead to cooling elements (8), and **in that** the third specimen-head level (33) of the specimen head (30) has a cooling-liquid inlet (82) and a cooling-liquid outlet (83), and also a gas inlet (92) and a gas outlet (93) for the process gas, and **in that** the measurement window (12), which is located in the optical temperature-measuring channel (9), is recessed centrally into the third specimen-head level (33) of the specimen head (30).

37.  Device according to Claim 36, **characterized in that** the three specimen-head levels (31 to 33) consist of ultrapure aluminium.


**Revendications**

1.  Procédé pour fabriquer des passages traversants électriquement conducteurs dans un semi-conducteur en forme de plaquette, à l'aide d'une thermo-migration par production d'un gradient de température entre deux surfaces opposées du semi-conducteur (10), la première surface étant chauffée uniformément d'une manière répartie sur son étendue, jusqu'à une température de travail du processus de thermo-migration comprise entre 800°C et 1100°C et étant ensuite réduite à une température de prélèvement et une substance dopante conductrice étant appliquée sur la seconde surface et la seconde surface étant refroidie uniformément d'une manière répartie uniformément sur son étendue,
    **caractérisé en ce**
    **que** la surface supérieure est située à une première distance (a), d'une source de chaleur (6) et que la seconde surface est située à une seconde distance (b) d'un dispositif de refroidissement (11) et que la puissance totale de l'apport de chaleur dans le semi-conducteur (10) et/ou la distribution de puissance de l'apport de chaleur sur la surface devant être chauffée du semi-conducteur (10) est réglée en fonction de la température, mesurée en au moins un point de mesure de température sur le semi-conducteur (10), par modification des première et seconde distances (a1, a2).

2.  Procédé selon la revendication 1, **caractérisé en ce que** le semi-conducteur (10) est disposé dans un système fermé (2, 3) qui est bon conducteur de la chaleur et est rempli d'un gaz inerte.

3.  Procédé selon la revendication 2, **caractérisé en ce que** le gaz inerte est constitué d'hydrogène ou d'hélium.

4.  Procédé selon au moins l'une des revendications précédentes, **caractérisé en ce que** le semi-conducteur (10) peut être déplacé perpendiculairement à un plan situé entre la source de chaleur et le dispositif de refroidissement.

5.  Procédé selon au moins l'une des revendications précédentes, **caractérisé en ce que** les surfaces du semi-conducteur (10) sont disposées dans des espaces séparés les uns des autres.

6.  Procédé selon au moins l'une des revendications précédentes, **caractérisé en ce que** le rayonnement thermique est appliqué essentiellement perpendiculairement à la surface à chauffer du semi-conducteur (10).

7.  Procédé selon au moins l'une des revendications précédentes, **caractérisé en ce que** le semi-conducteur (10) est disposé sur un poinçon de test (3) mobile dans au moins un plan et qui se déplace entre une position de chargement et une position d'irradiation.

8.  Procédé selon au moins l'une des revendications précédentes, **caractérisé en ce que** la température du semi-conducteur (10) est mesurée à l'aidé d'un dispositif de mesure ampèremétrique (7) sans contact au moyen d'un canal de mesure optique (9).

9.  Procédé selon au moins l'une des revendications précédentes, **caractérisé en ce que** le chauffage du semi-conducteur (10) s'effectue avec un accroissement de température inférieur ou égal à 30 K/seconde, que la température est maintenue ensuite constante jusqu'à ce que le processus de thermo-migration soit terminé, qu'un refroidissement est exécuté dans une première phase de refroidissement avec un rayonnement thermique décroissant et qu'ensuite un refroidissement est exécuté pendant un intervalle de temps prédéterminé d'une manière libre jusqu'à la température de prélèvement.

**10.** Procédé selon la revendication 9, **caractérisé en ce que** le chauffage et le refroidissement du semi-conducteur (10) s'effectuent selon une fonction en rampe.

**11.** Procédé selon au moins l'une des revendications précédentes, **caractérisé en ce que** le semi-conducteur (10) est chauffé jusqu'à une première température prédéterminée comprise entre 300°C et 400°C, qu'une fois que le semi-conducteur (10) a atteint cette température, l'espace entourant le semi-conducteur (10) est nettoyé pendant un intervalle de temps prédéterminé, que le semi-conducteur (10) est chauffé de façon supplémentaire à une seconde température prédéterminé comprise entre environ 600°C et 700°C, pour laquelle la substance dopante conductrice réagit avec le corps de base semi-conducteur du semi-conducteur au moyen de la formation de gouttelettes, et qu'ensuite un chauffage est exécuté à la température de travail du processus de migration comprise entre environ 900°C et 1100°C, qu'à la fin du processus de thermo-migration, la température du semi-conducteur (10) est abaissée jusqu'à une troisième température prédéterminée d'environ 650°C et qu'ensuite le semi-conducteur (10) est refroidi pendant un intervalle de temps d'environ deux à trois minutes à une température de prélèvement prédéterminée.

**12.** Procédé selon au moins l'une des revendications 7 à 11, **caractérisé en ce que** le poinçon de test (3) est amené dans une position de prélèvement et de chargement et est ouvert pour la réception du semi-conducteur (10), qu'après le chargement du semi-conducteur (10) le poinçon de test (3) est amené dans une position fermée et un vide est établi dans le poinçon de test (3) et un balayage avec un gaz inerte est exécuté, qu'un liquide de refroidissement est introduit dans le poinçon de test (3) et que le semi-conducteur (10) est chauffé ou refroidi selon le programme prédéterminé, que le poinçon de test (3) est amené à nouveau dans la position de prélèvement et de chargement et que le semi-conducteur (10) est prélevé et est disposé dans un magasin balayé par de l'azote.

**13.** Dispositif pour fabriquer des passages électriquement conducteurs dans un semi-conducteur en forme de plaquette au moyen d'une thermo-migration par production d'un gradient de température entre deux surfaces opposées du semi-conducteur, dont l'une est tournée vers une source de chaleur (6) et l'autre surface est tournée vers un dispositif de refroidissement (11), et par application d'une substance dopante conductrice sur la surface tournée vers la source de chaleur (6) et comportant un support situé entre la source de chaleur (6) et le dispositif de refroidissement (11) et servant à recevoir le semi-conducteur, la source de chaleur (6) délivrant un rayonnement thermique homogène à la surface, tournée vers elle, du semi-conducteur (10),
**caractérisé en ce**
**que** le dispositif comporte une tête de mesure pyrométrique (7) servant à mesurer la température de surface du semi-conducteur (10) et que la distance entre le support (30) et la source de chaleur (6) et/ou entre le semi-conducteur (3) et le dispositif de refroidissement (11) peut être modifiée en fonction de la température de surface mesurée.

**14.** Dispositif selon la revendication 3, **caractérisé en ce que** l'espace entre la source de chaleur (6) et le dispositif de refroidissement (11) est encapsulé et est rempli d'un gaz inerte bon conducteur de la chaleur.

**15.** Dispositif selon la revendication 14, **caractérisé en ce qu'**en ce qui concerne le gaz il s'agit d'hydrogène ou d'hélium.

**16.** Dispositif selon la revendication 14 ou 15, **caractérisé en ce que** l'espace est subdivisé dans le plan du support (3).

**17.** Dispositif selon l'une des revendications 14 à 16, **caractérisé en ce que** la pression de gaz et/ou la circulation du gaz peut être modifiée dans l'espace ou dans les espaces.

**18.** Dispositif selon l'une des revendications précédentes 13 à 17, **caractérisé en ce que** la source de chaleur (6) est formée par un four chauffé d'une manière directe ou indirecte.

**19.** Dispositif selon la revendication 18, **caractérisé en ce que** le four possède une plaque (60), qui correspond essentiellement à la surface du support (3) et peut être chauffée au moyen d'un chauffage à résistance électrique, d'un chauffage inductif, d'un chauffage utilisant un faisceau d'électrons ou d'un chauffage à micro-ondes.

**20.** Dispositif selon la revendication 19, **caractérisé en ce que** la plaque (60) est formée d'un matériau à base de graphite scellé de façon pyrolytique avec du nitrure de bore.

**21.** Dispositif selon la revendication 19, **caractérisé en ce que** la plaque (60) est formée d'une céramique très pure.

**22.** Dispositif selon la revendication 13, **caractérisé en ce que** la source de chaleur (6) est constituée par un champ de lampes à halogène (61 ou 62) qui s'étend au moins sur la surface du semi-conducteur (10).

**23.** Dispositif selon l'une des revendications 13 ou 22, **caractérisé en ce que** la source de chaleur (6) est formée de deux champs croisés de lampes à halogène (61, 62) disposés dans deux plans.

**24.** Dispositif selon au moins l'une des revendications précédentes 13 à 23, **caractérisé en ce qu'**un réflecteur (13) est disposé sur le côté de la source de chaleur (6) situé à l'opposé du support (3).

**25.** Dispositif selon au moins l'une des revendications précédentes 13 à 24, **caractérisé en ce que** le support (3) est constitué par un cadre (3a) qui est déplaçable dans un plan parallèle à l'étendue longitudinale de la source de chaleur (6).

**26.** Dispositif selon au moins l'une des revendications précédentes 13 à 24, **caractérisé en ce que** le support (3) est constitué par des tiges ou des barrettes (3a), qui sont reliées au dispositif de refroidissement (8) et qui supportent de façon ponctuelle ou linéaire la surface du semi-conducteur (10) tournée vers le dispositif de refroidissement (11).

**27.** Dispositif selon au moins l'une des revendications précédentes 13 à 26, **caractérisé en ce que** le support (3) est constitué par un poinçon de test (3) relié au dispositif de refroidissement (11, 11a).

**28.** Dispositif selon la revendication 27, **caractérisé en ce que** le poinçon de test (3) est constitué par un cylindre de test (35), par une tête de test (30) qui forme la surface de recouvrement du cylindre de test (35) et loge le semi-conducteur (10), par une bride de test (36) qui fait saillie extérieurement sur la face inférieure du cylindre de test (35) et une coupelle de levage (36, 37) qui ferme d'une manière étanche au gaz le cylindre de test (35) vers le côté inférieur.

**29.** Dispositif selon la revendication 28, **caractérisé en ce que** le poinçon de test (3) peut être introduit et ressorti, dans une direction axiale (direction Z) dans et hors d'un récipient (4), qui est constitué par une surface (40) de sortie du rayonnement, tournée vers la source de chaleur (6) et un cylindre en quartz (4).

**30.** Dispositif selon la revendication 29, **caractérisé en ce que** le récipient (4) est entouré d'une enveloppe extérieure de forme cylindrique. (5) et que l'enveloppe extérieure de forme cylindrique (5) est refroidie et/ou qu'un cylindre de refroidissement (11a) est disposé à l'intérieur du poinçon de test (3).

**31.** Dispositif selon au moins l'une des revendications 28 à 30, **caractérisé en ce que** la tête de mesure pyrométrique (7) est disposée d'une manière centrée à l'intérieur du cylindre de test (35) du poinçon de test (3) et est dirigée par l'intermédiaire d'un canal de mesure de température et de circulation de gaz (9) ainsi que d'une fenêtre de mesure (12) située dans le canal de mesure de température et de circulation de gaz (9), sur la surface du semi-conducteur (10) tournée vers la tête de test (30).

**32.** Dispositif selon la revendication 31, **caractérisé en ce que** la tête de mesure pyrométrique (7) possède un cône de mise au point réglable de façon précise.

**33.** Dispositif selon la revendication 31 ou 32, **caractérisé en ce que** la tête de mesure pyrométrique (7) travaille avec une longueur d'onde de 2,2 $\mu$m.

**34.** Dispositif selon la revendication 31, 32, 33, **caractérisé en ce que** la tête de mesure pyrométrique (7) est fixée et ajustée au moyen d'une bride (70) de pyromètre sur le poinçon de test (3) et que le cône de mise au point (71) de la tête de mesure pyrométrique (7) est dirigé sur la surface du semi-conducteur (10) de telle sorte qu'il apparaît un faible spot de mesure au centre du semi-conducteur (10).

**35.** Dispositif selon la revendication 34, **caractérisé en ce que** la fenêtre de mesure (12) est formée de saphir ($Al_2O_3$).

**36.** Dispositif selon au moins l'une des revendications précédentes 13 à 35, **caractérisé en ce que** la tête de test (30) possède trois plans (31, 32, 33), parmi lesquels le premier plan (31) de la tête de test est relié au logement du semi-conducteur (10), ce plan possédant le canal central de mesure de température et de circulation de gaz (9) ainsi que plusieurs canaux de circulation de gaz (90) qui sont répartis radialement et sont guidés en diagonale dans le premier plan (31) de la tête de test, et dans lesquels est guidé un gaz bon conducteur de la chaleur et qui sort par des ouvertures en forme de buses des canaux (9 ou 90), circule au-dessous du semi-conducteur (10) et est amené par l'intermédiaire d'une ouverture (95) dans la partie formant socle du cylindre de test (35),
que le second plan (32) de la tête de test (30) comporte des canaux diagonaux de circulation de gaz (91), le canal central de mesure de la température et de circulation de gaz (9) et des canaux (81) de circulation d'eau de refroidissement, qui conduisent à des éléments de refroidissement (8), et
que le troisième plan (33) de la tête de test (30) comporte une entrée (82) pour le liquide de refroidissement et une sortie (83) pour le liquide de refroidissement ainsi qu'une entrée (92) et une sortie (93) pour le gaz de traitement, et
que la fenêtre de mesure (12) située dans le canal optique de mesure de température (9) est aménagée d'une manière centrée dans le troisième plan (33) de la tête de test (30).

37. Dispositif selon la revendication 36, **caractérisé en ce que** les trois plans (31 à 33) de la tête de test sont formés d'aluminium très pur.

# Fig. 1

# Fig. 2a

25

60

3a

$a_1$

$a_2$

11

# Fig. 2b

10

# Fig. 2c

6

W

3c

10

11

# F i g . 2 d

EP 0 991 797 B1

# Fig. 3

24

# Fig. 4

# Fig. 5

# Fig. 6

# Fig. 7